(19) Europäisches Patentamt
European Patent Office
Office européen des brevets

(11) EP 4 632 491 A2

(12) **EUROPEAN PATENT APPLICATION**

(43) Date of publication:
**15.10.2025 Bulletin 2025/42**

(21) Application number: **25162242.9**

(22) Date of filing: **07.03.2025**

(51) International Patent Classification (IPC):
*G03G 15/04 (2006.01)*

(52) Cooperative Patent Classification (CPC):
**G03G 15/04063; G03G 15/04054; G03G 15/04072**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.03.2024 JP 2024047054**

(71) Applicant: **CANON KABUSHIKI KAISHA**
**Tokyo 146-8501 (JP)**

(72) Inventors:
- **NISHIDE, Yosuke**
  **Tokyo, 146-8501 (JP)**
- **IWAWAKI, Hironobu**
  **Tokyo, 146-8501 (JP)**
- **YAMADA, Naoki**
  **Tokyo, 146-8501 (JP)**

(74) Representative: **TBK**
**Bavariaring 4-6**
**80336 München (DE)**

(54) **IMAGE FORMING APPARATUS**

(57) An image forming apparatus (40) includes an exposure light source (28) including an organic light emitting element and a photoconductor (27) configured to receive light (29) emitted from the organic light emitting element, wherein a light emitting intensity of the organic light emitting element at end of supply of current to the organic light emitting element is defined as $L_0$, a period from the end of supply of current to the organic light emitting element to quenching of the organic light emitting element is defined as T1, a period from start of supply of current to the organic light emitting element to the end of supply of current to the organic light emitting element is defined as T2, and T2 is larger than T1.

FIG. 1A

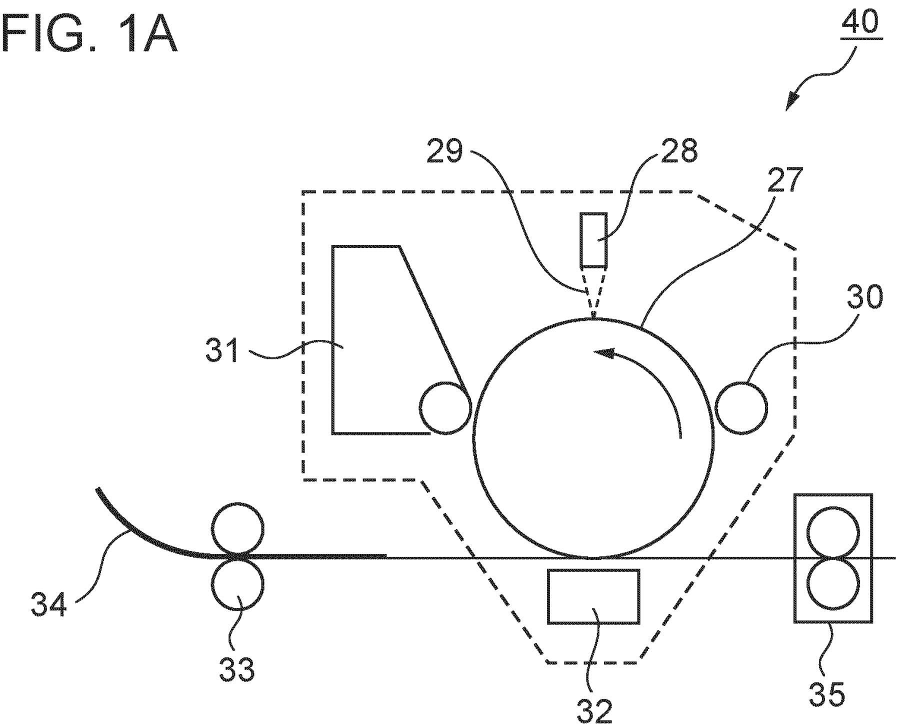


EP 4 632 491 A2

## Description

### BACKGROUND OF THE DISCLOSURE

#### Field of the Disclosure

The present disclosure relates to an image forming apparatus.

#### Description of the Related Art

Image forming apparatuses using the electrophotographic mode are widely and commonly used as copiers, facsimile apparatuses, and printers. Such an image forming apparatus is an image forming apparatus including an exposure light source including a light emitting unit. The light emitting element employed is an LED (Light Emitting Diode) or an organic light emitting element (OLED: Organic Light Emitting Diode). Such a light emitting element emits light, which is used to expose a photoconductor drum (hereafter, may be referred to as "photoconductor") using an organic electrophotographic photoconductor (OPC: Organic Photoconductor), to print an image corresponding to a latent image formed on the photoconductor drum, on a recording paper sheet.

Japanese Patent Laid-Open No. 2007-128040 (PTL 1) describes an image forming apparatus including an exposure light source using an organic light emitting element (hereafter, may be referred to as "organic electroluminescence element" or "organic EL element").

Organic light emitting elements emit light continuously even after end of supply of current and the light emitting intensity attenuates as the time elapses. Thus, when an organic light emitting element is used as an exposure light source, light emitted from the organic light emitting element after end of supply of current (hereafter, may be referred to as "afterglow") needs to be considered.

However, PTL 1 does not suggest the relation between the exposure time of the photoconductor using the organic light emitting element (hereafter, may be referred to as "organic electroluminescence element" or "organic EL element") and the time from the end of supply of current to the organic light emitting element to quenching, and therefore has a problem in image quality.

### SUMMARY OF THE DISCLOSURE

The present disclosure provides an image forming apparatus that can provide high image quality.

The present disclosure in its first aspect provides an image forming apparatus as specified in claims 1 to 3 and 5 to 15.

The present disclosure in its second aspect provides an image forming apparatus as specified in claims 4 to 15.

Further features of the present disclosure will become apparent from the following description of exemplary embodiments with reference to the attached drawings.

### BRIEF DESCRIPTION OF THE DRAWINGS

Fig. 1A is a schematic view of an example of an image forming apparatus according to an embodiment of the present disclosure.

Fig. 1B is a schematic view of an example of an exposure light source in an image forming apparatus according to an embodiment of the present disclosure. Fig. 1C is a schematic view of an example of an exposure light source in an image forming apparatus according to an embodiment of the present disclosure.

Fig. 2 is a graph showing light emitting intensity vs. time during the operation of an image forming apparatus according to an embodiment.

Fig. 3 is a schematic view illustrating a form of a light emitting device according to an embodiment.

Fig. 4A is a schematic perspective view of a head substrate. Fig. 4B illustrates the arrangement of a plurality of light emitting elements disposed on the head substrate. Fig. 4C is an enlarged view of a portion of Fig. 4B.

### DESCRIPTION OF THE EMBODIMENTS

In this Specification, the light emitting intensity of an organic light emitting element at end of supply of current to the organic light emitting element is defined as $L_0$; the period from end of supply of current to the organic light emitting element to quenching of the organic light emitting element is defined as T1; the period of start of supply of current to the

organic light emitting element to end of supply of current to the organic light emitting element is defined as T2; and the period from end of supply of current to the organic light emitting element to start of supply of current to the organic light emitting element is defined as T3.

Note that "quenching of an organic light emitting element" refers to a state in which the light emitting intensity lowers such that the organic light emitting element cannot form a latent image on a photoconductor. For example, quenching of an organic light emitting element may be at a timing when the light emitting intensity reaches $L_0/2$, may be at a timing when the light emitting intensity reaches $L_0/e$, or may be at a timing when the light emitting intensity reaches $L_0/10$. e is the Napier's number.

In this Specification, the host material is, among compounds constituting the light emitting layer, a compound having the highest mass ratio. The guest material is, among compounds constituting the light emitting layer, a compound having a lower mass ratio than the host and causing the main light emission. The assist material is, among compounds constituting the light emitting layer, a compound having a lower mass ratio than the host material and assisting light emission of the guest material. Note that the assist material is also referred to as the second host. The host material can also be referred to as the first compound. The assist material can also be referred to as the second compound.

Image forming apparatus

An image forming apparatus according to an embodiment will be described with reference to drawings.

Fig. 1A is a schematic view illustrating an example of an image forming apparatus according to an embodiment of the present disclosure. An image forming apparatus 40 is an electrophotographic image forming apparatus, and includes a photoconductor 27, an exposure light source 28, a charging unit 30, a development unit 31, a transfer unit 32, a conveyor roller 33, and a fixing unit 35. The photoconductor 27 and the exposure light source 28 are disposed so as to face each other. The exposure light source 28 emits light 29 to form an electrostatic latent image on the surface of the photoconductor 27. The exposure light source 28 includes a single organic light emitting element or a plurality of organic light emitting elements. Specifically, the light 29 emitted from the organic light emitting element of the exposure light source 28 is received by the photoconductor 27, to thereby form an electrostatic latent image on the surface of the photoconductor 27. The exposure light source 28 may further include a lens array. The exposure light source 28 may include a plurality of light emitting element rows or may include a single light emitting element row. The development unit 31 includes toner or the like. The charging unit 30 charges the photoconductor 27. The transfer unit 32 transfers the developed image to a recording medium 34. The conveyor roller 33 conveys the recording medium 34. The recording medium 34 is, for example, a paper sheet. The fixing unit 35 fixes the image formed on the recording medium 34.

Fig. 1B and Fig. 1C are schematic views of the exposure light sources 28 in which a plurality of light emitting units 36 are arranged on substrates. Arrows 37 indicate directions parallel to the axes of the photoconductors and indicate row directions in which the light emitting units 36 including organic light emitting elements are arranged. The row directions are the same as the directions of the rotation axes of the photoconductors 27. Such a direction can also be referred to as the long-axis direction of the photoconductor 27. Fig. 1B illustrates a form in which the light emitting units 36 are arranged in the long-axis direction of the photoconductor 27. Fig. 1C illustrates a form different from that of Fig. 1B and, in the form, the light emitting units 36 in the first row and the second row are alternately arranged in the row direction. The first row and the second row are disposed at positions different in the column direction. In the first row, the plurality of light emitting units 36 are arranged with gaps therebetween. In the second row, the light emitting units 36 are arranged at positions corresponding to the gaps between the light emitting units 36 of the first row. In other words, also in the column direction, the plurality of light emitting units 36 are arranged with gaps therebetween. The arrangement in Fig. 1C may also be referred to as, for example, a grid arrangement pattern, a houndstooth check pattern, or a checkered pattern.

The image forming apparatus according to the embodiment has the following feature (a) or (b).

(a) Organic light emitting element satisfies $T1 < T2$
(b) Organic light emitting element satisfies $T1 < T3$

Hereinafter, these will be described.

(a) Organic light emitting element satisfies $T1 < T2$

The image forming apparatus according to the embodiment has a feature in which T2 is longer than T1. Because of this feature, the image forming apparatus according to the embodiment can provide high image quality.

Referring to Fig. 2, the image forming apparatus according to the embodiment will be specifically described. In Fig. 2, the timing at which the light emitting intensity of the organic light emitting element reaches $L_0/e$ is defined as the quenching timing of the organic light emitting element. In Fig. 2, t1 and t1' are timings of supply of current to the organic light emitting element, t2 and t2' are timings of end of supply of current to the organic light emitting element, and t3 and t3' are

timings of quenching of the organic light emitting element. The period from t1 to t2 can also be referred to as a first light emitting period; the period from t1' to t2' can also be referred to as a second light emitting period; and the subsequent periods can be referred to as a third light emitting period and a fourth light emitting period. T1 is a period from t2 to t3 or a period from t2' to t3'. T2 is a period from t1 to t2 or a period from t1' to t2'. In this Specification, T1 may be referred to as afterglow lifetime.

Note that Fig. 2 illustrates a non-limiting embodiment in which the organic light emitting element emits light at the same light emitting intensity in the first light emitting period and in the second light emitting period. Alternatively, the first light emitting period and the second light emitting period may be different in light emitting intensity. Specifically, the light emitting intensity of the first light emitting period may be higher than the light emitting intensity of the second light emitting period, or the light emitting intensity of the first light emitting period may be lower than the light emitting intensity of the second light emitting period. The light emitting intensity may vary during the first (second) light emitting period,

The image forming apparatus according to the embodiment selects, on the basis of the data of the image to be formed, organic light emitting elements (pixels) for light emission and exposes the rotating photoconductor 27 to form a latent image. At this time, after the end of supply of current to the organic light emitting elements, afterglow may be emitted to the photoconductor 27, to thereby form an unintended latent image on the photoconductor 27. In order to address this, in the organic light emitting elements of the image forming apparatus according to the embodiment, T1 is **made to** be shorter than T2, to thereby reduce occurrence of vertical streaks, ghost, or the like. Because of this feature, formation of unintended latent images on the photoconductor 27 can be suppressed, so that the image forming apparatus according to the embodiment can provide high image quality.

In the image forming apparatus according to the embodiment, the value of T2/T1 is more than 1.0, or 10 or more, or 20 or more, or 100 or more. The value of T2/T1 may be 1000 or less, may be 500 or less, or may be 1000 or less. Specifically, the value of T2/T1 may be $1.0 < T2/T1 \leq 100$, may be $1.0 < T2/T1 \leq 500$, or may be $1.0 < T2/T1 \leq 1000$. T1 may be 10 $\mu$s or less, may be 2 $\mu$s or less, may be 1 $\mu$s or less, may be less than 1 $\mu$s, may be 50 ns or less, or may be 10 ns or less.

(b) Organic light emitting element satisfies T1 < T3

The image forming apparatus according to the embodiment has a feature in which T3 is longer than T1. Because of this feature, the image forming apparatus according to the embodiment can provide high image quality.

Referring to Fig. 2, the image forming apparatus according to the embodiment will be specifically described. In Fig. 2, the timing at which the light emitting intensity of the organic light emitting element reaches $L_0/e$ is defined as the quenching timing of the organic light emitting element. In Fig. 2, t1 and t1' are timings of supply of current to the organic light emitting element, t2 and t2' are timings of end of supply of current to the organic light emitting element, and t3 and t3' are timings of quenching of the organic light emitting element. The period from t1 to t2 can also be referred to as a first light emitting period; the period from t1' to t2' can also be referred to as a second light emitting period; and the subsequent periods can be referred to as a third light emitting period and a fourth light emitting period. T1 is a period from t2 to t3 or a period from t2' to t3'. T3 is a period from t2 to t1' or a period from t2' to start of supply of current to the organic light emitting element in the third light emitting period. In this Specification, T1 may be referred to as afterglow lifetime and T3 may be referred to as light emission interval period.

Note that Fig. 2 illustrates a non-limiting embodiment in which the organic light emitting element emits light at the same light emitting intensity in the first light emitting period and in the second light emitting period. Alternatively, the first light emitting period and the second light emitting period may be different in light emitting intensity. Specifically, the light emitting intensity of the first light emitting period may be higher than the light emitting intensity of the second light emitting period, or the light emitting intensity of the first light emitting period may be lower than the light emitting intensity of the second light emitting period. The light emitting intensity may vary during the first (second) light emitting period,

The image forming apparatus according to the embodiment selects, on the basis of the data of the image to be formed, organic light emitting elements (pixels) for light emission and exposes the rotating photoconductor 27 to form a latent image. At this time, after the end of supply of current to the organic light emitting elements, afterglow may be emitted to the photoconductor 27, to thereby form an unintended latent image on the photoconductor 27. Specifically, afterglow from the organic light emitting elements to the photoconductor 27 causes formation of a latent image, which may lead to occurrence of vertical streaks, ghost, or the like. In order to address this, in the organic light emitting elements of the image forming apparatus according to the embodiment, T1 is made to be shorter than T3. Because of this feature, formation of unintended latent images on the photoconductor 27 can be suppressed, so that the image forming apparatus according to the embodiment can provide high image quality.

In the image forming apparatus according to the embodiment, the value of T3/T1 is more than 1.0, or 5.0 or more, or 10 or more, or 15 or more, or 20 or more, or 50 or more. The value of T3/T1 may be $1.0 < T3/T1 \leq 5$, may be $1.0 < T3/T1 \leq 15$, may be $1.0 < T3/T1 \leq 20$, or may be $1.0 < T3/T1 \leq 50$. T1 may be 10 $\mu$s or less, may be 2 $\mu$s or less, may be 1 $\mu$s or less, may be less than 1 $\mu$s, may be 50 ns or less, or may be 10 ns or less.

Note that an image forming apparatus according to another embodiment may have both of the features (a) and (b). The image forming apparatus having both of the features (a) and (b) can provide higher image quality.

Note that the image forming apparatus according to the embodiment may further have the following features. When the image forming apparatus has such a feature, it may have any one of the following (c) to (g), or may have a plurality of features among (c) to (g).

(c) Organic light emitting element has top emission structure
(d) Organic light emitting element includes light emitting layer containing light emitting material and the light emitting material emits fluorescence
(e) Organic light emitting element includes light emitting layer containing light emitting material and the light emitting material emits phosphorescence
(f) Organic light emitting element includes light emitting layer containing light emitting material and the light emitting material emits delayed fluorescence
(g) Organic light emitting element includes a plurality of pixels arranged two-dimensionally at high density

Hereinafter, these features will be described.

(c) Organic light emitting element has top emission structure

The image forming apparatus according to the embodiment can have a top emission structure. The top emission structure provides higher light extraction efficiency than the bottom emission structure. The bottom emission structure is a light emission form in which light is extracted from the side of a pixel circuit described later. The top emission structure is a light emission form in which light is extracted from a side opposite from the side of the pixel circuit described later.

In the embodiment, the organic light emitting element can have an interference structure. Specifically, when the organic light emitting element includes, sequentially from the substrate side, a reflective layer, a first electrode, a light emitting layer, and a second electrode, the optical distance between the reflective electrode and the light emitting layer is set such that the emission wavelength is intensified. In this case, a layer formed of an insulating material or a transparent material such as ITO (indium tin oxide) or IZO (indium zinc oxide) may be disposed between the reflective layer and the first electrode. When the organic light emitting element includes, sequentially from the substrate side, a first electrode, a light emitting layer, and a second electrode, light emitted from the light emitting layer can be intensified between the first electrode and the second electrode. In this case, the first electrode can reflect light emitted from the light emitting layer.

(d) Organic light emitting element includes light emitting layer containing light emitting material and the light emitting material emits fluorescence

The image forming apparatus according to the embodiment can have a configuration in which the organic light emitting element includes a light emitting layer containing a light emitting material and the light emitting material emits fluorescence.

In general, light emission from the singlet excitation state is known to have a particularly short afterglow lifetime. As described above, short afterglow lifetime can provide high image quality and hence light emission from the singlet excitation state can be employed. Specifically, the light emission from the singlet excitation state can be fluorescence emission.

The image forming apparatus according to the embodiment may be caused to emit light at a high light emitting intensity and hence the light emitting material needs to be stable during repeated light emission processes. For this reason, the light emitting material that emits fluorescence may be a light emitting material having a condensed polycyclic hydrocarbon skeleton; specifically, the skeleton may have a perylene skeleton. In particular, the light emitting material that emits fluorescence may be a hydrocarbon compound. The reason for this is that hydrocarbon compounds have high bond stability and deterioration during repeated light emission can be suppressed. Non-limiting specific examples of the light emitting material that emits fluorescence include Exemplary compounds RD1 to RD6 described later.

From another viewpoint, for the light emitting material, a freely rotatable single bond may be a carbon-carbon bond, a freely rotatable single bond may be an sp2 carbon-sp2 carbon bond, all the freely rotatable single bonds may be carbon-carbon bonds, and all the freely rotatable single bonds may be sp2 carbon-sp2 carbon bonds. In this Specification, the freely rotatable single bond refers to the single bond of "A-B" in which a unit A and a unit B are bonded via the single bond and the unit A and the unit B are not fused. The units A and B may be atoms such as carbon atoms or nitrogen atoms or molecules such as benzene or carbazole. Table 1 describes bond energies of bonds.

Table 1

| F 1 | F 2 | F 3 | F 4 |
|---|---|---|---|
| 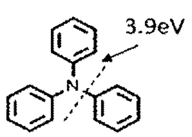 | 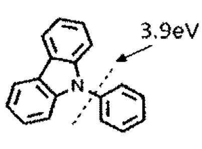 | 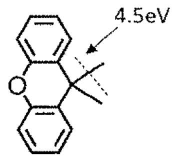 | 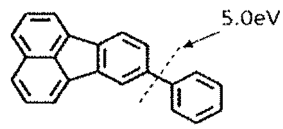 |

F1 and F2, which have a carbon-nitrogen bond, have a bond energy of 3.9 eV. On the other hand, F3, which has a freely rotatable carbon-carbon bond, has a bond energy of 4.5 eV and F4, which has a freely rotatable bond between sp2 carbons, has a bond energy of 5.0 eV.

Thus, when the freely rotatable single bond is a carbon-carbon bond, the skeleton is less likely to be degraded and may be more useful. Of carbon-carbon bonds, the bond between sp2 carbons has particularly high bond energy. Thus, a skeleton in which a freely rotatable single bond is an sp2 carbon-sp2 carbon bond is even less likely to be degraded and hence can be more useful.

The image forming apparatus according to the embodiment may contain, in the light emitting layer of the organic light emitting element, a first organic compound different from the light emitting material that emits fluorescence. The first organic compound may be a compound having the lowest excitation singlet energy higher than the lowest excitation singlet energy of the light emitting material that emits fluorescence. The first organic compound can have a condensed polycyclic hydrocarbon skeleton, specifically a naphthalene skeleton, an anthracene skeleton, a phenanthrene skeleton, a fluorene skeleton, a pyrene skeleton, a triphenylene skeleton, a chrysene skeleton, a tetracene skeleton, or a perylene skeleton. In the first organic compound, a freely rotatable single bond may be a carbon-carbon bond, a freely rotatable single bond may be an sp2 carbon-sp2 carbon bond, all the freely rotatable single bonds may be carbon-carbon bonds, and all the freely rotatable single bonds may be sp2 carbon-sp2 carbon bonds.

The image forming apparatus according to the embodiment may contain, in the light emitting layer of the organic light emitting element, a delayed fluorescence material different from the light emitting material that emits fluorescence. Specifically, the delayed fluorescence material is a compound in which the difference between the lowest excitation singlet energy and the lowest excitation triplet energy is 0.20 eV or less. The use of the delayed fluorescence material can provide reverse intersystem crossing of excitons from the triplet state to the singlet state. The delayed fluorescence material may be a compound having the lowest excitation singlet energy higher than the lowest excitation singlet energy of the light emitting material that emits fluorescence. When the light emitting layer contains a delayed fluorescence material, it may further contain the above-described first organic compound. This configuration is referred to as the TADF Assisted Fluorescence (TAF) configuration and exhibits higher luminous efficacy than ordinarily used fluorescence emission.

Note that, in this Specification, the light emitting material that emits fluorescence may contain a non-fluorescent light emitting component. For example, in addition to fluorescence, delayed fluorescence or phosphorescence may be included. Note that the content of the fluorescent emitting component needs to be higher than the contents of the other light emitting components. The same applies to the light emitting material that emits phosphorescence and the light emitting material that emits delayed fluorescence.

(e) Organic light emitting element includes light emitting layer containing light emitting material and the light emitting material emits phosphorescence

The image forming apparatus according to the embodiment can have a configuration in which the organic light emitting element includes a light emitting layer containing a light emitting material and the light emitting material emits phosphorescence.

In general, excitons generated by electric energy are distributed in the triplet state and the singlet state in a ratio of 3:1 and hence the light emitted from the triplet state (phosphorescence) is known to have higher luminous efficacy than the light emitted from the singlet state (fluorescence). For this reason, the image forming apparatus according to the embodiment has high luminous efficacy.

The light emitting material that emits phosphorescence may be a compound containing a metal complex, and can be an iridium complex or a platinum complex. Examples of the ligand of the metal complex include a substituted or unsubstituted phenyl-isoquinoline ligand, a substituted or unsubstituted phenylquinoline ligand, a substituted or unsubstituted phenyl-benzoisoquinoline ligand, and a substituted or unsubstituted phenyl-naphthoisoquinoline ligand. Non-limiting specific examples include Exemplary compounds RD9 to RD16 described later.

The image forming apparatus according to the embodiment may contain, in the light emitting layer of the organic light emitting element, a second organic compound different from the light emitting material that emits phosphorescence.

The second organic compound may be a compound having the lowest excitation triplet energy higher than the lowest excitation triplet energy of the light emitting material that emits phosphorescence. The second organic compound can be a compound having a condensed polycyclic hydrocarbon skeleton that may have a substituent or a heterocyclic skeleton that may have a substituent. From another viewpoint, for the second organic compound, a freely rotatable single bond may be a carbon-carbon bond, a freely rotatable single bond may be an sp2 carbon-sp2 carbon bond, all the freely rotatable single bonds may be carbon-carbon bonds, and all the freely rotatable single bonds may be sp2 carbon-sp2 carbon bonds.

The condensed polycyclic hydrocarbon skeleton may be a skeleton having 10 or more and 25 or less carbon atoms and specific examples include a naphthalene skeleton, a fluorene skeleton, an anthracene skeleton, a phenanthrene skeleton, a pyrene skeleton, a chrysene skeleton, a triphenylene skeleton, a tetracene skeleton, a fluoranthene skeleton, and a perylene skeleton.

The heterocyclic skeleton may be a skeleton having 3 or more and 30 or less carbon atoms, or may be a skeleton having 3 or more and 18 or less carbon atoms; examples include a dibenzofuran skeleton, a dibenzothiophene skeleton, a xanthone skeleton, a thioxanthone skeleton, a carbazole skeleton, an indolocarbazole skeleton, and a triazine skeleton.

The second organic compound can be a compound having a triphenylene skeleton, a xanthone skeleton, or an indolocarbazole skeleton. These are skeletons having high planarity and hence provide higher mobility of electric charges. Thus, the organic light emitting element is expected to have a lower driving voltage.

(f) Organic light emitting element includes light emitting layer containing light emitting material and the light emitting material emits delayed fluorescence

The image forming apparatus according to the embodiment can have a configuration in which the organic light emitting element includes a light emitting layer containing a light emitting material and the light emitting material emits delayed fluorescence. The delayed fluorescence used herein refers to fluorescence emitted by reverse intersystem crossing of excitons or fluorescence emitted by triplet-triplet fusion (TTF).

In the image forming apparatus according to the embodiment, the light emitting layer contains a delayed fluorescence material. The delayed fluorescence material is a compound in which the difference between the lowest excitation singlet energy and the lowest excitation triplet energy is 0.20 eV or less. The use of the delayed fluorescence material can provide reverse intersystem crossing of excitons from the triplet state to the singlet state. In this case, the light emitting layer may further contain the first organic compound described in (d) and the first organic compound may be a compound having the lowest excitation singlet energy higher than the lowest excitation singlet energy of the delayed fluorescence material.

In general, excitons generated by electric energy are known to be distributed in the triplet state and the singlet state in a ratio of 3:1. The delayed fluorescence material contained can cause reverse intersystem crossing of excitons distributed in the triplet state into the singlet state, so that the organic light emitting element exhibits higher luminous efficacy. For this reason, the image forming apparatus according to the embodiment has high luminous efficacy.

The image forming apparatus according to the embodiment may have a configuration in which the light emitting layer employs TTF. TTF refers to a configuration in which collision between triplet excitons is caused, to thereby generate excitons having higher energy, which are used for light emission from the singlet state. The use of TTF can provide triplet excitons for fluorescence emission, so that the resultant organic light emitting element has high luminous efficacy.

(g) Organic light emitting element includes a plurality of pixels arranged two-dimensionally at high density

The image forming apparatus according to the embodiment includes a plurality of pixels two-dimensionally arranged in the rotational direction of the photoconductor and in the rotational axis direction of the photoconductor. As a result, organic light emitting elements are two-dimensionally packed at high density, to thereby achieve an increase in the light emitting intensity during exposure. Specifically, the organic light emitting elements may be packed at 600 dpi or more, may be packed at 1200 dpi or more, may be packed at 2400 dpi or more, or may be packed at 4800 dpi or more.

The increase in the light emitting intensity considerably contributes to the mechanism including a series of processes in which the photoconductor layer of the photoconductor is efficiently excited and electric charges are rapidly moved to the charge transport substance, so that residual charges can be suppressed and deterioration of the image quality can be suppressed.

Hereinafter, the configuration of the exposure light source 28 in the image forming apparatus according to the embodiment will be described further in detail.

First embodiment

Fig. 3 is a schematic view of a form of a light emitting device in an image forming apparatus according to this embodiment. The light emitting device according to the embodiment has a rectangular shape having long sides parallel to

a first direction and short sides parallel to a direction intersecting the first direction. For example, the first direction may be a direction extending in the rotational axis direction of the photoconductor of the image forming apparatus.

A substrate 1701 has a polygonal shape. Hereinafter, an example of the substrate 1701 that is rectangular will be described. In this Specification, for the rectangular substrate 1701, the long side direction is referred to as the first direction while the short side direction orthogonal to the long side direction is referred to as the second direction. The term "polygon" used in this Specification encompasses shapes including a rounded corner. On the rectangular substrate 1701, a moisture-resistant ring 1700 that suppresses or prevents entry of moisture into the light emitting device is disposed. The moisture-resistant ring 1700 can be, for example, a guard ring constituted by a wiring layer.

Within the moisture-resistant ring 1700, a light emitting region 1702, a contact region 1703 (shown as 1703_1 through 1703_5), a pad 1704 (shown as 1704_1 through 1704_3), and a circuit 1706 (shown as 1706_1 through 1706_2) are disposed. In this embodiment, the contact region 1703 includes a first contact region 1703_1, a second contact region 1703_2, and a third contact region 1703_3. The pad 1704 includes a first pad 1704_1, a second pad 1704_2, and a third pad 1704_3.

The circuit 1706 are some circuits for driving the light emitting device. The circuit 1706 includes a first circuit 1706_1 and a second circuit 1706_2. Non-limiting specific examples include an input protection circuit, an input circuit to which data items for driving is input, and a logic circuit for processing data.

Within the light emitting region 1702, light emitting elements ELs are arranged in the column direction and in the row direction. The light emitting elements ELs include organic light emitting elements having features according to an embodiment of the present disclosure. The contact region 1703 is a region where wiring electrically connected to the common electrode of the light emitting elements ELs is disposed. The pad 1704_1 electrically connects the contact region 1703 to an external element.

The moisture-resistant ring 1700 may have an outer peripheral shape including a plurality of recessed portions. These portions can be used as, for example, abutting regions against which ribs that are parts of a vapor-deposition mask in the film forming step are abutted.

The plurality of light emitting elements ELs arranged in the column direction and in the row direction in the light emitting region 1702 each include, as described above, the light emitting layer, the first electrode and the second electrode that sandwich the light emitting layer therebetween. This embodiment describes an example in which the first electrodes are independent electrodes individually disposed in the light emitting elements ELs and the second electrode is a common electrode disposed so as to be shared by the light emitting elements ELs.

For example, in the light emitting region 1702, when four rows of the light emitting elements ELs are arranged, as exemplified in Fig. 3, the position of the first light emitting element EL in the first row and the position of the first light emitting element EL in the second row may be displaced, in the X-direction (row direction), by 1/4 of the X-direction size of the light emitting element EL. In the case of n rows where n is an integer of 2 or more, the position of the first light emitting element EL in the first row and the position of the first light emitting element EL in the second row may be displaced, in the X-direction, by 1/n of the X-direction size of the light emitting element EL. Such a configuration is advantageous for increasing the resolution.

The contact region 1703 is a region adjacent to the light emitting region 1702 of the substrate 1701 and is disposed within the moisture-resistant ring 1700. At least one of the first contact region 1703, the pad 1704, and the circuit 1706 is disposed, together with the recessed portions of the moisture-resistant ring 1700, between the light emitting region 1702 and one of the long-side edges of the substrate 1701, and may be disposed in line in the long-side direction.

In such a case where the contact region 1703, the pad region 1704, the circuit 1706, and the like are disposed at the same position in the short-side direction, the short-side length of the light emitting device can be reduced to thereby achieve reduction in the size of the light emitting device.

The light emitting device of this embodiment includes, along the long-side edge of the light emitting device, the plurality of contact regions 1703 for the common electrode of the light emitting elements ELs and the power supply wiring. When the common electrode is formed of, for example, a transparent electrode material having a relatively high electric resistance, the amount of voltage drop in the long-axis direction may be large. Thus, the voltages applied to OLEDs vary depending on the distance from the contact region to which the potential is supplied. As a result, OLEDs to which a voltage is applied in order to cause light emission at the same luminance (light emitting intensity), may be actually different in emission luminance (light emitting intensity), which may result in shading or the like. In this embodiment in which the plurality of contact regions 1703 are disposed in the long-axis direction, voltage drop of the common electrode in the long-side direction can be suppressed, to suppress occurrence of shading or the like.

## Second embodiment

In this embodiment, referring to Fig. 4, an example of applying a light emitting device to a head substrate 1800 of an exposure head of an image forming apparatus will be described.

Fig. 4A is a schematic perspective view of the head substrate 1800. Fig. 4B illustrates the arrangement of a

plurality of light emitting elements ELs disposed in the head substrate 1800. Fig. 4C is an enlarged view of a portion of Fig. 4B.

On the head substrate 1800, an LED chip 1803 is mounted. The LED chip 1803 can be, for example, the light emitting device described in the first embodiment.

As illustrated in Fig. 4A, the LED chip 1803 is disposed on one surface of the head substrate 1800, and an elongated flexible flat cable (FFC) connector 1807 is disposed on the other surface of the head substrate 1800. The one surface of the head substrate 1800 is a surface (the upper surface or the front surface) on which the LED chip 1803 is disposed. The other surface of the substrate is a surface (the lower surface or the back surface) opposite from the surface on which the LED chip 1803 is disposed.

The FFC connector 1807 is attached to the other surface (the lower surface or the back surface) of the head substrate 1800 such that the longitudinal direction of the FFC connector 1807 extends in the longitudinal direction of the head substrate 1800. The elongated FFC connector 1807 is disposed in order to input control signals (driving signals) from a control circuit unit of the main body of the image forming apparatus. The control signals are transmitted to the LED chips 1803.

The LED chip 1803 is driven (to emit light or to quench emission) in accordance with control signals input into the head substrate 1800.

The LED chip 1803 mounted on the head substrate 1800 will be described. As illustrated in Fig. 4B and Fig. 4C, the plurality of light emitting elements ELs are disposed on one surface of the head substrate 1800. For example, LED chips 1803_1 to 1803_29 (29 chips) are arranged. Fig. 4B illustrates, as examples, LED chips 1803_1, 1803_13, 1803_14, 1803_15, 1803_16, and 1803_29. For each of the LED chips 1803_1 to 1803_29, a plurality of light emitting elements ELs are disposed in the longitudinal direction of the chip; for example, 516 light emitting elements ELs are arranged.

An intercentral distance K2 of light emitting elements ELs adjacent to each other in the longitudinal direction of the LED chip 1803 corresponds to the resolution of the image forming apparatus. For example, when the image forming apparatus of the embodiment has a resolution of 1200 dpi, the light emitting elements ELs are arranged in the longitudinal direction of the LED chips 1803_1 to 1803_29 such that the intercentral distance K2 of adjacent light emitting elements ELs is 21.16 μm. Thus, the exposure head of the embodiment has an exposure range of about 314 mm.

In the photoconductor drum, the photoconductor layer is formed so as to have a width of 314 mm or more. The long-side length of A4-sized recording paper sheets and the short-side length of A3-sized recording paper sheets are 297 mm and the exposure head according to the embodiment has an exposure range with which images can be formed on A4-sized recording paper sheets and A3-sized recording paper sheets. Note that Figs. 4B and 4C illustrate an example in which a plurality of light emitting elements ELs are arranged in the longitudinal direction; alternatively, light emitting elements ELs may be arranged in, in addition to the longitudinal direction, the transverse direction.

The LED chips 1803_1 to 1803_29 are arranged in a plurality of rows in the axial direction of the photoconductor drum. Specifically, the LED chips 1803_1 to 1803_29 are alternately arranged in two rows in the axial direction of the photoconductor drum. As illustrated in Fig. 4B, the LED chips 1803_1, 1803_3, ..., 1803_29, which are positioned at odd numbers from the left side, are mounted in a single row in the longitudinal direction of the substrate 1800. In addition, the LED chips 1803_2, 1803_4, ..., 1803_28, which are positioned at even numbers from the left side, are mounted in a single row in the longitudinal direction of the substrate 1800. The LED chip 1803 is disposed in this way.

As a result, as illustrated in Fig. 4C, in the longitudinal direction of the LED chip 1803, the intercentral distance K1 of the light emitting elements ELs and the intercentral distance K2 of the light emitting elements ELs can be made equal to each other. The intercentral distance K1 of the light emitting elements ELs refers to the intercentral distance between the light emitting element EL disposed at an end of the LED chip 1803_13 and the light emitting element EL disposed at an end of the LED chip 1803_14. The intercentral distance K2 of the light emitting elements ELs refers to the intercentral distance K2 of adjacent light emitting elements ELs in the LED chip 1803_14. Components other than ELs are omitted from FIG. 4C.

In other words, the intercentral distance K1 between adjacent light emitting elements ELs disposed at an end of an LED chip 1803 and at an end of another LED chip 1803 can be made equal to the intercentral distance K2 of adjacent light emitting elements ELs on a single LED chip 1803.

Note that, in the embodiment, the light emitting elements ELs are organic light emitting elements and are current-driving-type light emitting elements. The organic light emitting elements are disposed, for example, on a TFT (Thin Film Transistor) substrate, on a line in the main scanning direction (axial direction of the photoconductor drum 27) and are electrically connected in parallel via a power supply wiring similarly disposed in the main scanning direction.

Note that, in the case of applying the light emitting device to an exposure head in which exposure is linearly performed, for the shape of the light emitting region 1702, the ratio of the longitudinal (first direction X) length to the transverse (second direction Y) length is large, compared with the case of applying the light emitting device to display apparatuses or the like. For the shape of the substrate of the LED chip, the ratio of the longitudinal (first direction X) length to the transverse (third direction Y) length is also large.

Specifically, for example, the long-side length of the LED chip (or the light emitting region 1702) may be 5 times or more, or 10 times or more the short-side length of the LED chip (or the light emitting region 1702). For example, the long-side length of the LED chip (or the light emitting region 1702) can be made 20 times or more the short-side length of the LED chip (or the light emitting region 1702).

The long-side length of an LED chip depends on the axial length of the photoconductor drum 27, the number of LED chips disposed in the axial direction, and the arrangement of the LED chip 1803. The short-side length of the LED chip 1803 depends on whether light emitting elements ELs are arranged, in a direction perpendicular to the axis of the photoconductor drum, in the light emitting region 1702, or the arrangement of the pad 1704 or the contact region 1703.

The organic light emitting element may have a configuration including a light emitting layer that emits red light from the viewpoint of the wavelength dependency of the photosensitivity of the photoconductor drum 27.

The LED chip 1803 may include a color filter. With the color filter, stray light in the unintended direction can be absorbed without decrease in the amount of regular light incident on the photoconductor drum, so that the printing quality can be improved.

Organic light emitting element

Hereinafter, the organic light emitting element will be described in detail. However, the present disclosure is not limited to the description.

Specific examples of the element configuration of the organic light emitting element according to the embodiment include multilayer element configurations in which electrode layers and organic compound layers described in the following (A) to (F) are sequentially stacked on a substrate.

Note that, in any of the element configurations, the organic compound layer necessarily includes a light emitting layer containing a light emitting material.

(A) anode/light emitting layer/cathode
(B) anode/hole transport layer/light emitting layer/electron transport layer/cathode
(C) anode/hole transport layer/light emitting layer/electron transport layer/electron injection layer/cathode
(D) anode/hole injection layer/hole transport layer/light emitting layer/electron transport layer/cathode
(E) anode/hole injection layer/hole transport layer/light emitting layer/electron transport layer/electron injection layer/cathode
(F) anode/hole transport layer/electron blocking layer/light emitting layer/hole blocking layer/electron transport layer/cathode

However, these examples of element configurations are non-limiting examples of basic element configurations. For example, the following various layer configurations can be employed: an insulating layer, a bonding layer, or an interference layer is disposed at the interface between an electrode and an organic compound layer; the electron transport layer or the hole transport layer is constituted by two layers having different ionization potentials; or the light emitting layer is constituted by two layers containing different light emitting materials.

For the organic light emitting element according to the embodiment, as needed, publicly known compounds such as a low-molecular-weight or high-molecular-weight hole injection compound or hole transport compound, a compound serving as the host, a light emitting compound, an electron injection compound, and an electron transport compound can also be used. Hereinafter, examples of such compounds will be described.

The hole injection transport material can be a material that has high hole mobility in order to facilitate injection of holes from the anode and to transport the injected holes to the light emitting layer. In order to suppress deterioration of film quality such as crystallization in the organic light emitting element, a material having high glass transition temperature can be used. Examples of the low-molecular-weight or high-molecular-weight material having the hole injection transport capability include triaryl amine derivatives, aryl carbazole derivatives, phenylenediamine derivatives, stilbene derivatives, phthalocyanine derivatives, porphyrin derivatives, poly(vinylcarbazole), poly(thiophene), and other conductive polymers. The hole injection transport material is also suitably used for the electron blocking layer. The following are non-limiting specific examples of compounds used as the hole injection transport material.

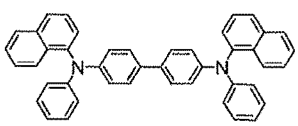
HT1

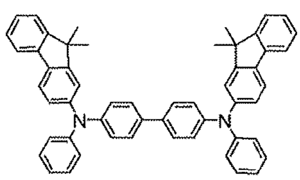
HT2

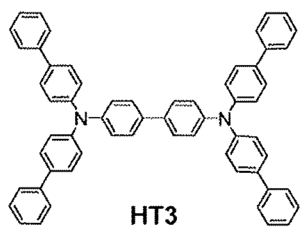
HT3

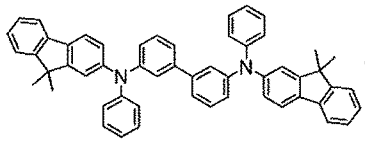
HT4

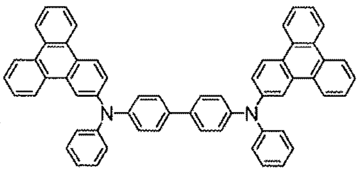
HT5

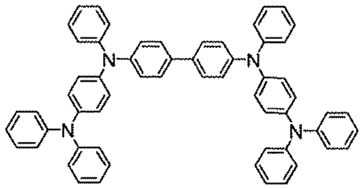
HT6

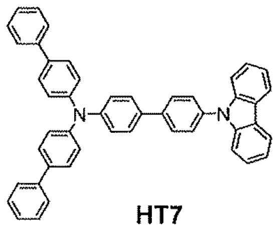
HT7

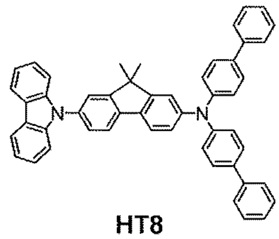
HT8

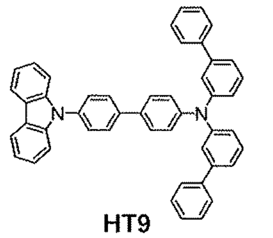
HT9

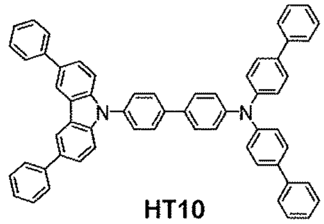
HT10

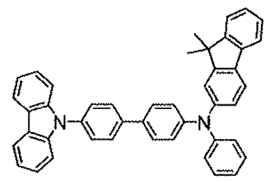
HT11

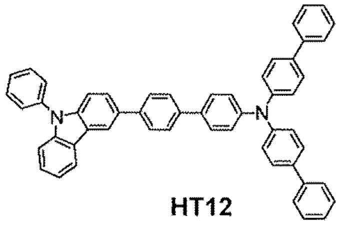
HT12

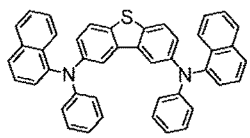
HT13

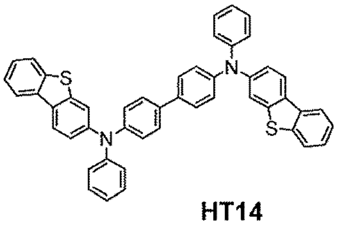
HT14

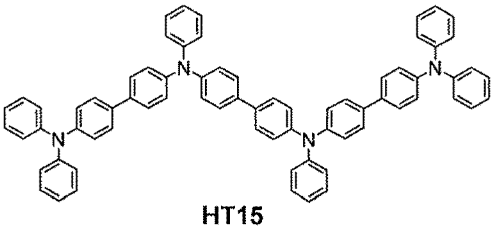
HT15

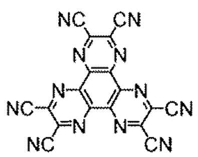
HT16

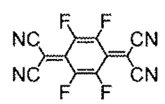
HT17

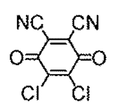
HT18

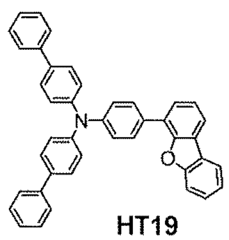
HT19

Examples of the light emitting material mainly relating to the light emitting function include fused-ring compounds (such as fluorene derivatives, naphthalene derivatives, pyrene derivatives, perylene derivatives, tetracene derivatives, anthracene derivatives, and rubrene), quinacridone derivatives, coumarin derivatives, stilbene derivatives, organoaluminum complexes such as tris(8-quinolinolato) aluminum, iridium complexes, platinum complexes, rhenium complexes, copper complexes, europium complexes, ruthenium complexes, and polymer derivatives such as poly(phenylenevinylene) derivatives, poly(fluorene) derivatives, and poly(phenylene) derivatives. The concentration of the light emitting material relative to the total mass of the light emitting layer may be 0.01 mass% or more and 20 mass% or less, or 0.1 mass% or more and 10 mass% or less. The following are non-limiting specific examples of compounds used as the light emitting material.

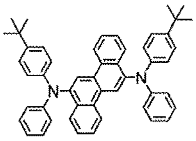
BD1
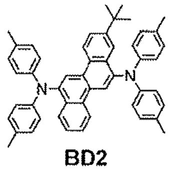
BD2
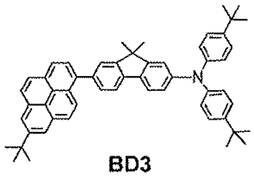
BD3
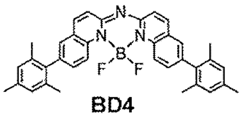
BD4

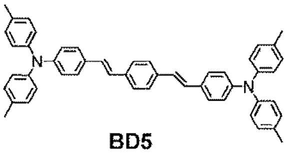
BD5
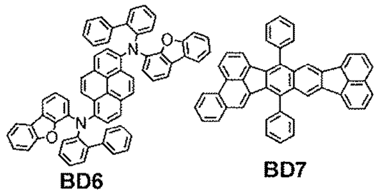
BD6
BD7
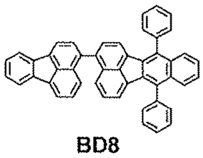
BD8

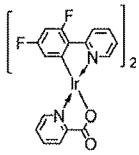
BD9
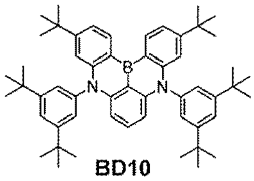
BD10

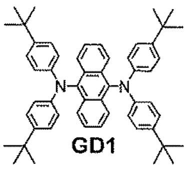
GD1
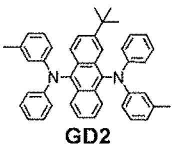
GD2
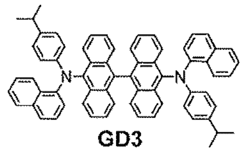
GD3
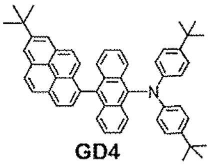
GD4

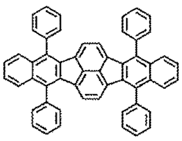
GD5
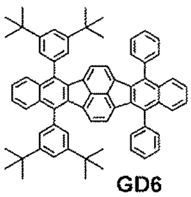
GD6
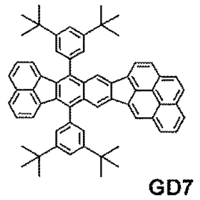
GD7
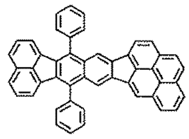
GD8

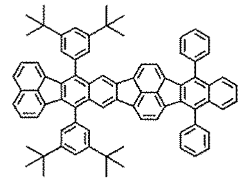
GD9
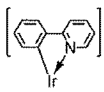
GD10
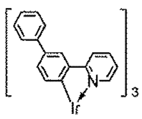
GD11
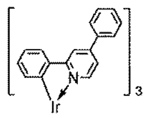
GD12
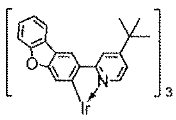
GD13

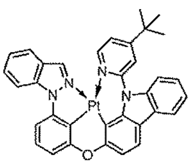
GD14
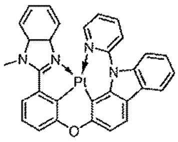
GD15
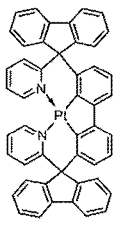
GD16
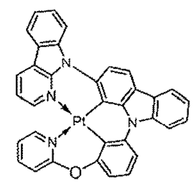
GD17
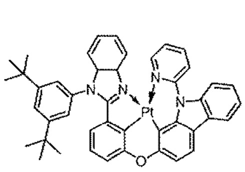
GD18

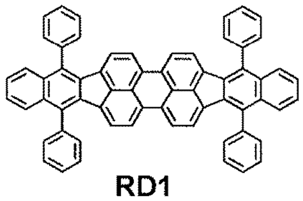

RD1

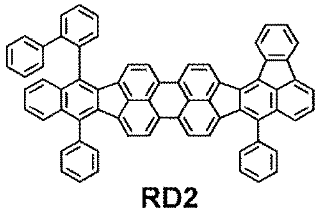

RD2

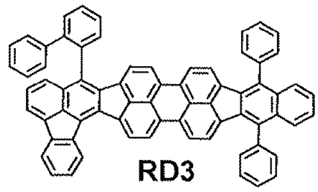

RD3

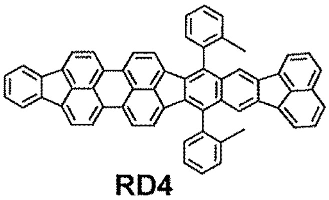

RD4

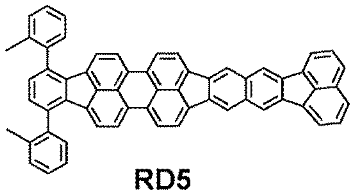

RD5

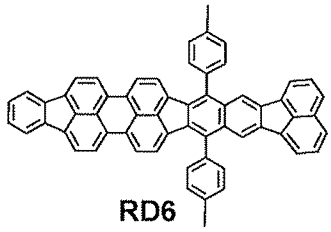

RD6

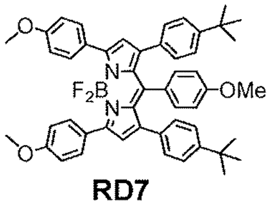

RD7

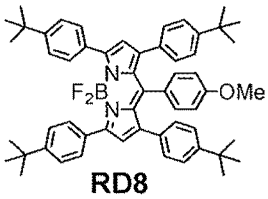

RD8

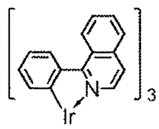

RD9

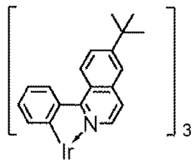

RD10

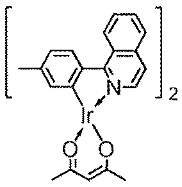

RD11

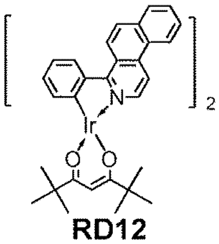

RD12

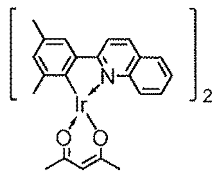

RD13

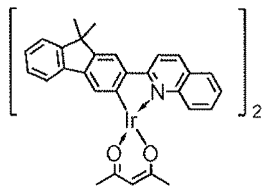

RD14

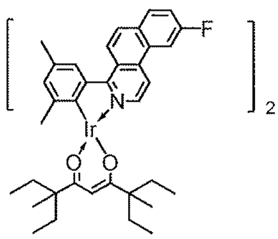

RD15

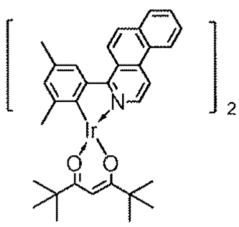

RD16

Non-limiting specific examples of the host or assist contained in the light emitting layer include aromatic hydrocarbon compounds or derivatives thereof, carbazole derivatives, azine derivatives, xanthone derivatives, dibenzofuran derivatives, dibenzothiophene derivatives, organoaluminum complexes such as tris(8-quinolinolato) aluminum, and organoberyllium complexes. The following are specific examples.

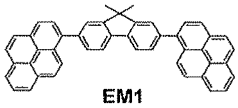

EM1

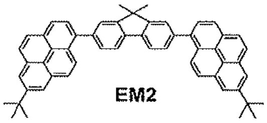

EM2

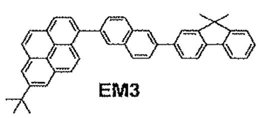

EM3

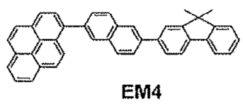

EM4

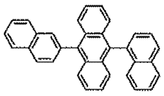
EM5

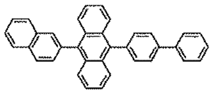
EM6

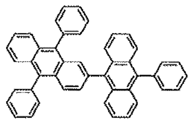
EM7

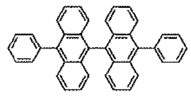
EM8

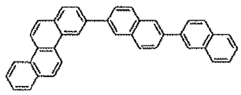
EM9

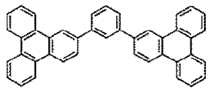
EM10

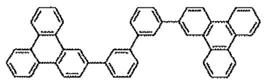
EM11

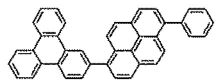
EM12

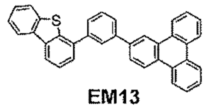
EM13

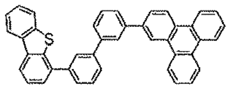
EM14

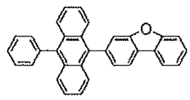
EM15

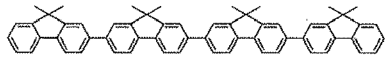
EM16

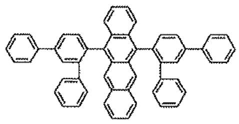
EM17

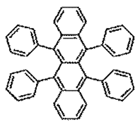
EM18

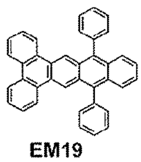
EM19

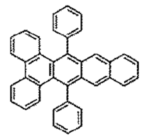
EM20

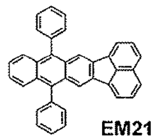
EM21

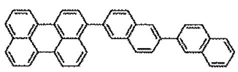
EM22

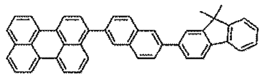
EM23

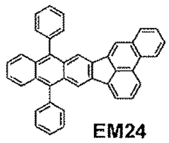
EM24

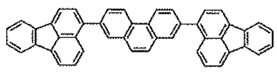
EM25

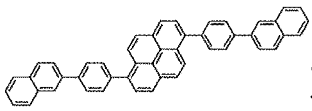
EM26

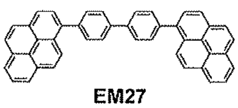
EM27

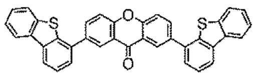
EM28

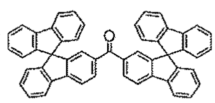
EM29

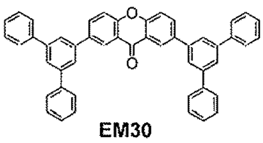
EM30

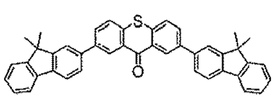
EM31

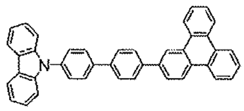
EM32

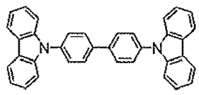
EM33

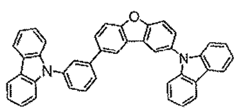
EM34

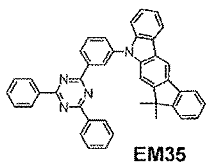
EM35

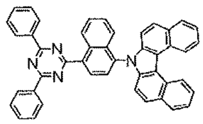
EM36

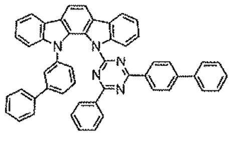
EM37

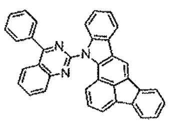
EM38

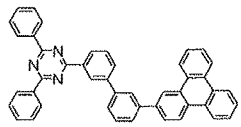
EM39

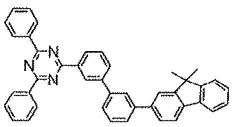
EM40

The electron transport material can be appropriately selected from materials that can transport electrons injected from the cathode to the light emitting layer and is selected in consideration of, for example, the balance with the hole mobility of the hole transport material. Examples of the material having the electron transport capability include oxadiazole

derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds (such as fluorene derivatives, naphthalene derivatives, chrysene derivatives, and anthracene derivatives). The electron transport material is also suitably used for the hole blocking layer.

The following are non-limiting specific examples of compounds used as the electron transport material. The following are specific examples.

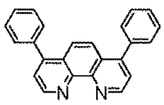
ET1
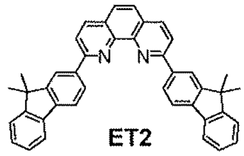
ET2
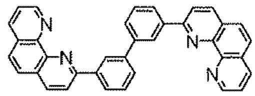
ET3
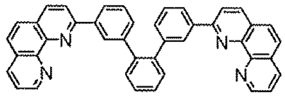
ET4

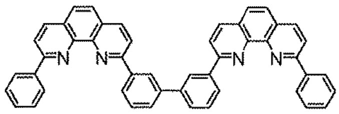
ET5
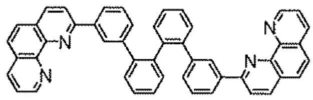
ET6
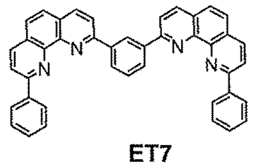
ET7

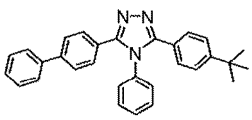
ET8
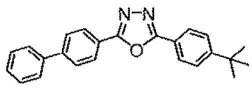
ET9
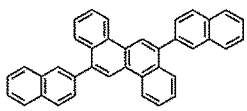
ET10
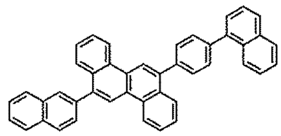
ET11

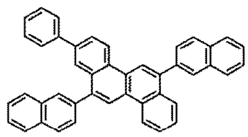
ET12
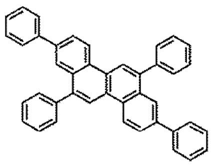
ET13
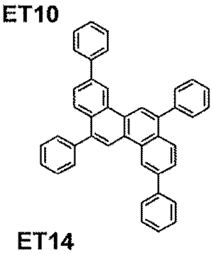
ET14
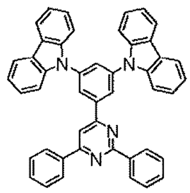
ET15

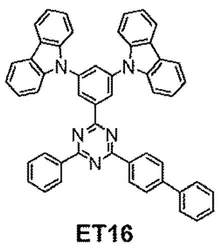
ET16
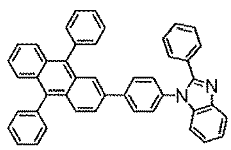
ET17
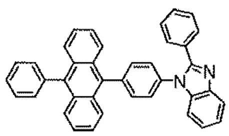
ET18
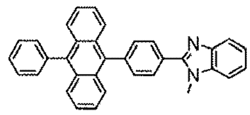
ET19

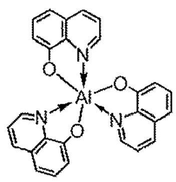
ET20
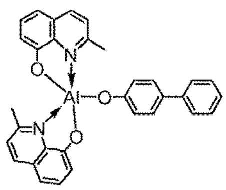
ET21
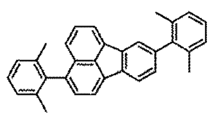
ET22
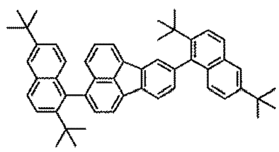
ET23

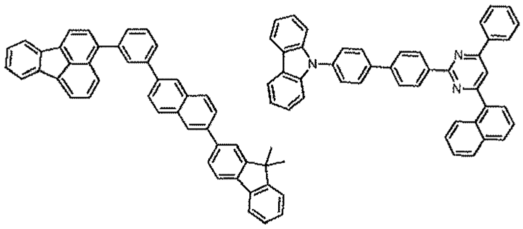
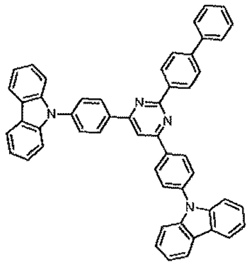
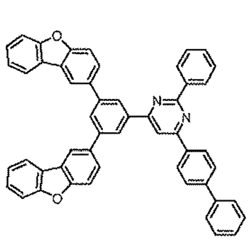

ET24 ET25 ET26 ET27

The electron injection material can be appropriately selected from materials that can easily achieve electron injection from the cathode and is selected in consideration of the balance with the hole injection performance or the like. As organic compounds, an n-type dopant and a reducing dopant are also contained. Examples include alkali metal-containing compounds such as lithium fluoride, lithium complexes such as lithium quinolinol, benzoimidazolidene derivatives, imidazolidene derivatives, fulvalene derivatives, and acridine derivatives. The electron injection material can also be used together with the above-described electron transport material.

Non-limiting examples of the light emitting material that emits light from the singlet excitation state in the present disclosure include compounds represented by BD1 to BD8, BD10, GD1 to GD9, and RD1 to RD8.

Non-limiting examples of the phosphorescence emitting material that emits light from the triplet excitation state in the present disclosure include compounds represented by BD9, GD10 to GD18, and RD9 to RD16.

Non-limiting examples of the TADF material in the present disclosure include compounds represented by EM35 to EM38.

More detailed configuration of organic light emitting element

Hereinafter, the organic light emitting element according to the embodiment will be described further in detail. The organic light emitting element is disposed by forming, on a substrate, an insulating layer, a first electrode, an organic compound layer, and a second electrode. On the second electrode, a protective layer, a color filter, a microlens, or the like may be disposed. In the case of disposing a color filter, a planarization layer may be disposed between the color filter and the protective layer. The planarization layer can be formed of an acrylic resin or the like. The same applies to a case where a planarization layer is disposed between the color filter and the microlens.

Substrate

The substrate may be a substrate of quartz, glass, a silicon wafer, resin, metal, or the like. On the substrate, a switching element such as a transistor and wiring are disposed, over which an insulating layer may be disposed. The insulating layer may be formed of any material as long as a contact hole can be formed so as to form wiring to the first electrode and insulation from unconnected wiring can be ensured. Examples of the material include resins such as polyimide, silicon oxide, and silicon nitride. Electrodes

As the electrodes, a pair of electrodes can be used. The pair of electrodes may be an anode and a cathode.

When an electric field is applied in the direction in which the organic light emitting element emits light, the electrode at the higher potential is the anode while the other electrode is the cathode. In other words, the electrode that supplies holes to the light emitting layer is the anode while the electrode that supplies electrons to the light emitting layer is the cathode.

The constituent material of the anode can be a material having a high work function as much as possible. Examples of the material include elemental metals such as gold, platinum, silver, copper, nickel, palladium, cobalt, selenium, vanadium, and tungsten, mixtures of the foregoing, alloys of combinations of the foregoing, and metal oxides such as tin oxide, zinc oxide, indium oxide, indium tin oxide (ITO), and indium zinc oxide. Other examples include conductive polymers such as polyaniline, polypyrrole, and polythiophene.

These electrode materials may be used alone or in combination of two or more thereof. The anode may be constituted by a single layer or may be constituted by a plurality of layers.

In the case of using such an electrode as a reflective electrode, it may be formed of, for example, chromium, aluminum, silver, titanium, tungsten, molybdenum, an alloy of the foregoing, a multilayered structure of the foregoing, or the like. Such a material can be used to provide a reflective film that does not serve as an electrode. In the case of using such an electrode as a transparent electrode, non-limiting examples include oxide transparent conductive layers of indium tin oxide (ITO), indium zinc oxide, or the like.

The electrodes can be formed by photolithography.

On the other hand, the constituent material of the cathode can be a material having a lower work function. Examples of the constituent material include alkali metals such as lithium, alkaline-earth metals such as potassium, elemental metals such as aluminum, titanium, manganese, silver, lead, and chromium, and mixtures containing the foregoing. Alternatively, alloys of combinations of such elemental metals can also be used. Examples include magnesium-silver, aluminum-lithium, aluminum-magnesium, silver-copper, and zinc-silver. Metal oxides such as indium tin oxide (ITO) can also be used. Such electrode materials can be used alone or in combination of two or more thereof. The cathode may have a monolayer configuration or a multilayer configuration. In particular, silver may be used and, in order to reduce aggregation of silver, a silver alloy may be used. As long as aggregation of silver can be reduced, any alloy ratio is employed. For example, the ratio of silver to the other metal may be 1: 1, 3: 1, or the like.

The cathode is not particularly limited: a conductive layer of an oxide such as ITO may be used to provide a top emission element, or a reflective electrode of aluminum (Al) or the like may be used to provide a bottom emission element. The method for forming the cathode is not particularly limited; but, for example, direct-current or alternating-current sputtering can be used, so that the film coverage is high and the resistance tends to lower.

Organic compound layer

The organic compound layer at least includes a light emitting layer and may appropriately include, in addition to the light emitting layer, for example, a hole injection layer, a hole transport layer, or an electron blocking layer on the anode side and a hole blocking layer, an electron transport layer, or an electron injection layer on the cathode side as needed. The organic compound layer is mainly formed of an organic compound, but may contain inorganic atoms or an inorganic compound. The organic compound layer may contain, for example, copper, lithium, magnesium, aluminum, iridium, platinum, molybdenum, or zinc.

The organic compound layer constituting an organic light emitting element according to an embodiment of the present disclosure can be formed by a dry process such as the vacuum deposition method, the ionization deposition method, sputtering, or plasma. Alternatively, instead of the dry process, a wet process of dissolving the material in an appropriate solvent and performing a publicly known coating method (such as spin coating, dipping, the casting method, the LB method, or the ink jet method) to form the layer can also be used.

In such a case of performing the vacuum deposition method, the solution coating method, or the like to form the layer, crystallization and the like are less likely to occur and high stability over time is provided. When the coating method is performed to form the film, an appropriate binder resin may be additionally used to form the film.

Non-limiting examples of the binder resin include polyvinylcarbazole resins, polycarbonate resins, polyester resins, ABS resins, acrylic resins, polyimide resins, phenol resins, epoxy resins, silicone resins, and urea resins.

Such binder resins may be used alone as a homopolymer or a copolymer or in combination of two or more thereof. Furthermore, as needed, publicly known additives such as a plasticizer, an antioxidant, and an ultraviolet absorbent may be additionally used.

Charge generation layer

For a charge generation layer, a p layer and an n layer may be used to form an n/p junction, or a p-doped layer or an n-doped layer may be used. For example, when the charge generation layer is formed with a P/N junction alone, an electron injection layer can be formed in order that electrons having been extracted by the P layer are further injected into the electron transport layer. Alternatively, an n-doped layer/p-doped layer may be formed. Such a combination in the charge generation layer is not limited in the present disclosure.

For the p-doped layer, for example, a Lewis acid such as highly electron-withdrawing HAT-CN or molybdenum oxide and an aromatic amine-based compound may be mixed. HAT-CN and molybdenum trioxide are n-type materials and may be used as a multilayered configuration for extracting electrons. A p-doped layer or an np junction constituted by a multilayer of an n-type material and a p-type material is used as a p-charge generation layer.

The n-doped layer can be formed of a material that has a low work function and is easily subjected to electron doping, such as alkali metals and alkaline-earth metals. The n-doped layer is used as the n-charge generation layer in the present disclosure. Alternatively, LiF or the like may be combined with a reducing metal thin film to provide an electron injection layer and an n-type layer/p-type layer may be formed to generate charges.

Examples of the n dopant include alkali metals such as Li, Na, K, Rb, and Cs, alkaline-earth metals such as Mg, Ca, Sr, and Ba, rare earth metals such as Yb, compounds of the foregoing (alkali metal compounds (including oxides such as lithium oxide, halides, and carbonates such as lithium carbonate and cesium carbonate), alkaline-earth metal compounds (including oxides, halides, and carbonates), and rare earth metal compounds (including oxides, halides, and carbonates).

## Protective layer

On the second electrode, a protective layer may be disposed. For example, a glass plate over which a moisture absorbent is disposed can be placed on and bonded to the second electrode, to reduce entry of water and the like into the organic compound layer and to reduce occurrence of display failure. Alternatively, in another embodiment, a passivation film formed of silicon nitride or the like may be disposed on the second electrode, to reduce entry of water and the like into the organic compound layer. For example, the second electrode having been formed in a vacuum may be conveyed, within the vacuum, to another chamber, and a CVD process may be performed to form a silicon nitride film having a thickness of 2 μm and serving as the protective layer. After the CVD process is performed to form the film, an atomic layer deposition process (ALD process) may be performed to form the protective layer. The material for the film in the ALD process is not limited, and examples include silicon nitride, silicon oxide, and aluminum oxide. On the film formed by the ALD process, silicon nitride may be further formed by a CVD process. The film formed by the ALD process may have a film thickness smaller than that of the film formed by the CVD process. Specifically, the film formed by the ALD process may have a film thickness that is 50% or less, or 10% or less, of the film thickness of the film formed by the CVD process.

## Color filter

On the protective layer, a color filter may be disposed. For example, a color filter selected in accordance with the size of the organic light emitting element may be disposed on another substrate and this may be bonded to the substrate on which the organic light emitting element is disposed, or a color filter may be formed by patterning using photolithography on the protective layer. The color filter may be formed of a polymer.

## Planarization layer

A planarization layer may be disposed between the color filter and the protective layer. The planarization layer is disposed in order to reduce irregularities of the underlying layer. The planarization layer may also be referred to as a material resin layer in order not to limit the purpose of the layer. The planarization layer may be formed of an organic compound; the organic compound may be a low-molecular-weight compound or a high-molecular-weight compound and can be a high-molecular-weight compound.

Such planarization layers may be disposed over and under the color filter and the layers may be formed of the same constituent material or different constituent materials. Specific examples include polyvinylcarbazole resins, polycarbonate resins, polyester resins, ABS resins, acrylic resins, polyimide resins, phenol resins, epoxy resins, silicone resins, and urea resins.

## Microlens

The organic light emitting element or the light emitting apparatus including the organic light emitting element may include, on the emission side, an optical member such as a microlens. The microlens can be formed of an acrylic resin, an epoxy resin, or the like. The microlens may be disposed in order to increase the amount of light extracted from the organic light emitting element or the light emitting apparatus or to control the direction of extracted light. The microlens may have a hemispherical shape. When the microlens has a hemispherical shape, of the tangents touching the hemisphere, there is a tangent that is parallel to the insulating layer, and the point of tangency between the tangent and the hemisphere is the apex of the microlens. The apex of the microlens can be similarly determined in an appropriate sectional view. Specifically, of the tangents touching the semicircle of the microlens in a sectional view, there is a tangent parallel to the insulating layer and the point of tangency between the tangent and the semicircle is the apex of the microlens.

For the microlens, the midpoint can be defined. In a section of the microlens, an imaginary line segment extending from an end point of the arc to the other end point of the arc can be drawn and the midpoint of the line segment can be referred to as the midpoint of the microlens. The section in which the apex and the midpoint are determined may be a section perpendicular to the insulating layer. Opposite substrate

On the planarization layer, an opposite substrate may be disposed. The opposite substrate is disposed at a position corresponding to the above-described substrate and hence is referred to as the opposite substrate. The constituent material of the opposite substrate may be the same as that of the above-described substrate. When the above-described substrate is defined as a first substrate, the opposite substrate may be a second substrate.

## Pixel circuit

The light emitting apparatus including the organic light emitting element may include a pixel circuit connected to the organic light emitting element. The pixel circuit may be of an active matrix type configured to control independently

emission of each of a plurality of organic light emitting elements. The circuit of the active matrix type may be driven by the voltage programming mode or the current programming mode. The driving circuit includes a pixel circuit for each pixel. The pixel circuit may include an organic light emitting element, a transistor configured to control emission luminance (light emitting intensity) of the organic light emitting element, a transistor configured to control the emission timing, a capacitor configured to maintain the gate voltage of the transistor configured to control emission luminance (light emitting intensity), and a transistor connected to GND not via the light emitting element.

The light emitting apparatus includes a display region and a peripheral region disposed around the display region. The display region includes a pixel circuit and the peripheral region includes a display control circuit. The transistor constituting the pixel circuit may have a lower mobility than the transistor constituting the display control circuit.

The gradient of the voltage-current characteristics of a transistor constituting the pixel circuit may be smaller than the gradient of the voltage-current characteristics of a transistor constituting the display control circuit. The gradient of the voltage-current characteristics can be measured in, what is called, the Vg-Ig characteristics. The transistor constituting the pixel circuit is a transistor connected to the organic light emitting element.

Pixel

The light emitting apparatus including an organic light emitting element may include a plurality of pixels.

In such a pixel, a region referred to as a pixel aperture emits light. This region is the same as the first region. The pixel aperture may have a size of 15 μm or less, or may have a size of 5 μm or more. Specific examples of the size include 11 μm, 9.5 μm, 7.4 μm, and 6.4 μm.

The pixels can be disposed, in plan, in a publicly known arrangement form. The arrangement may be, for example, the stripe arrangement, the delta arrangement, the PenTile arrangement, or the Bayer arrangement. Examples of the shape of such a pixel include quadrangles such as rectangles and rhombuses and hexagons. Obviously, shapes that are not accurately rectangles but resemble rectangles are included in the rectangles. Such a shape of subpixels and such a pixel arrangement can be used in combination.

Hereinafter, the photoconductor 27 in the image forming apparatus according to the embodiment will be described in detail.

Photoconductor layer

The photoconductor layer of the photoconductor drum is mainly classified into (1) a multilayer-type photoconductor layer and (2) a monolayer-type photoconductor layer. The (1) multilayer-type photoconductor layer is a photoconductor layer including a charge generation layer containing a charge generation substance and a charge transport layer containing a charge transport substance. The (2) monolayer-type photoconductor layer is a photoconductor layer containing both of a charge generation substance and a charge transport substance.

(1) Multilayer-type photoconductor layer

The multilayer-type photoconductor layer includes a charge generation layer and a charge transport layer.

(1-1) Charge generation layer

The charge generation layer can contain a charge generation substance and a resin.

Examples of the charge generation substance include azo pigments, perylene pigments, polycyclic quinone pigments, indigo pigments, and phthalocyanine pigments. Of these, azo pigments and phthalocyanine pigments may be used. Of the phthalocyanine pigments, oxytitanium phthalocyanine pigments, chlorogallium phthalocyanine pigments, and hydroxygallium phthalocyanine pigments may be used.

**In** the charge generation layer, the content of the charge generation substance relative to the total mass of the charge generation layer may be 40 mass% or more and 85 mass% or less, or 60 mass% or more and 80 mass% or less.

Examples of the resin include polyester resins, polycarbonate resins, polyvinyl acetal resins, polyvinyl butyral resins, acrylic resins, silicone resins, epoxy resins, melamine resins, polyurethane resins, phenol resins, polyvinyl alcohol resins, cellulose resins, polystyrene resins, polyvinyl acetate resins, and polyvinyl chloride resins. Of these, polyvinyl butyral resins may be used.

The charge generation layer may further contain additives such as an antioxidant and an ultraviolet absorbent. Specific examples include hindered phenol compounds, hindered amine compounds, sulfur compounds, phosphorus compounds, and benzophenone compounds.

The charge generation layer can be formed by preparing a charge generation layer-forming coating solution containing the above-described materials and a solvent, using the coating solution to form a coating film on the underlying

layer, and drying the coating film. Examples of the solvent used for the coating solution include alcohol-based solvents, sulfoxide-based solvents, ketone-based solvents, ether-based solvents, ester-based solvents, and aromatic hydrocarbon-based solvents.

The charge generation layer may have a film thickness of 0.1 μm or more and 1 μm or less, or 0.15 μm or more and 0.4 μm or less.

(1-2) Charge transport layer

The charge transport layer can contain a charge transport substance and a binder material.

When a protective layer described later is not disposed, the charge transport layer serves as the surface layer of the photoconductor drum.

Examples of the charge transport substance include polycyclic aromatic compounds, heterocyclic compounds, hydrazone compounds, styryl compounds, enamine compounds, triarylamine compounds, and resins having a group derived from such a substance. Of these, triaryl amine compounds may be used.

In the charge transport layer, the content of the charge transport substance, relative to the total mass of the charge transport layer, may be 25 mass% or more and 70 mass% or less, or may be 30 mass% or more and 55 mass% or less.

The binder material employed is a thermoplastic resin (hereafter, may also be referred to as "resin").

Examples of the thermoplastic resin include polyester resins, polycarbonate resins, acrylic resins, and polystyrene resins. Of these, polycarbonate resins and polyester resins may be used. The polyester resins may be polyarylate resins.

The content ratio (mass ratio) of the charge transport substance to the resin may be 4: 10 to 20: 10, or 5: 10 to 12: 10.

The charge transport layer may contain additives such as an antioxidant, an ultraviolet absorbent, a plasticizer, and a leveling agent. Specific examples include hindered phenol compounds, hindered amine compounds, sulfur compounds, phosphorus compounds, benzophenone compounds, siloxane modified resins, silicone oil, polystyrene resin particles, polyethylene resin particles, and boron nitride particles.

The charge transport layer can be formed by preparing a charge transport layer-forming coating solution containing the above-described materials and a solvent, using the coating solution to form a coating film on the charge generation layer, and drying the coating film. Examples of the solvent used for the coating solution include alcohol-based solvents, ketone-based solvents, ether-based solvents, ester-based solvents, and aromatic hydrocarbon-based solvents. Of these solvents, ether-based solvents and aromatic hydrocarbon-based solvents may be used.

The charge transport layer may have a film thickness of 5 μm or more and 50 μm or less, or 8 μm or more and 40 μm or less, or 10 μm or more and 30 μm or less.

(2) Monolayer-type photoconductor layer

The monolayer-type photoconductor layer can be formed by preparing a photoconductor layer-forming coating solution containing a charge generation substance, a charge transport substance, a resin, and a solvent, using the coating solution to form a coating film on the underlying layer, and drying the coating film.

The charge generation substance, the charge transport substance, and the resin are the same as the above-described materials exemplified in "(1) Multilayer-type photoconductor layer".

Protective layer

In the present disclosure, a protective layer may be disposed on the photoconductor layer. The protective layer can provide improved durability.

When the protective layer is disposed, the protective layer serves as the surface layer of the photoconductor drum.

The protective layer may be formed as a cured film by polymerizing a raw material of the binder material such as a composition containing a monomer having a polymerizable functional group. In this case, examples of the reaction include a thermal polymerization reaction, a photopolymerization reaction, and a radiation polymerization reaction. For the monomer having a polymerizable functional group, examples of the polymerizable functional group include an isocyanate group, a blocked isocyanate group, a methylol group, alkylmethylol groups, an epoxy group, metal alkoxyl groups, a hydroxy group, an amino group, a carboxy group, a thiol group, carboxylic anhydride groups, and groups including a carbon-carbon double bond. Examples of the group including a carbon-carbon double bond include an acryloyl group and a methacryloyl group. As the monomer having a polymerizable functional group, a monomer having a charge transport capability may be used.

The cured product of the monomer having a polymerizable functional group is the binder material of the protective layer.

The monomer having a polymerizable functional group may be a hole transport compound having a chain-polymerizable functional group.

The hole transport compound having a chain-polymerizable functional group may be a compound represented by the following formula (CT-1) or (CT-2).

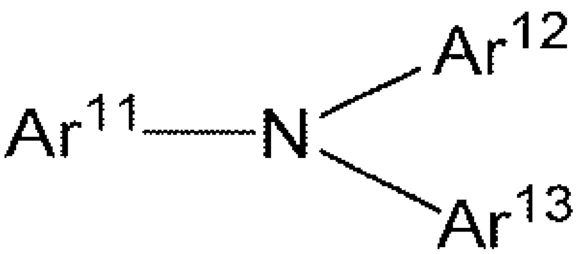

(CT-1)

In the formula (CT-1), $Ar^{11}$ to $Ar^{13}$ each independently represent a substituted aryl group or an unsubstituted aryl group. The substituent that the substituted aryl group may have is an alkyl group having 1 or more and 6 or less carbon atoms or a monovalent functional group represented by any one of formulas (P-1) to (P-3) described below. Note that the compound represented by the formula (CT-1) has at least one monovalent functional group represented by any one of the formulas (P-1) to (P-3) described below.

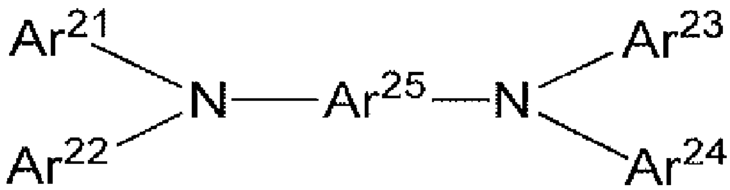

(CT-2)

In the formula (CT-2), $Ar^{21}$ to $Ar^{24}$ each independently represent a substituted aryl group or an unsubstituted aryl group, and $Ar^{25}$ represents a substituted arylene group or an unsubstituted arylene group. The substituent that the substituted aryl group may have is an alkyl group having 1 or more and 6 or less carbon atoms, or a monovalent functional group represented by the following formulas (P-1) to (P-3). The substituent that the substituted arylene group may have is an alkyl group having 1 or more and 6 or less carbon atoms, or a monovalent functional group represented by the following formulas (P-1) to (P-3). Note that the compound represented by the formula (CT-2) has at least one monovalent functional group represented by any one of the following formulas (P-1) to (P-3).

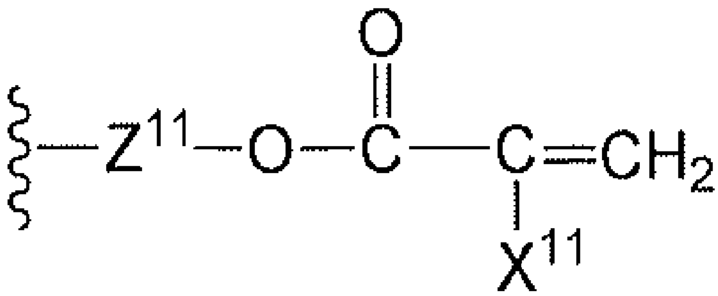

(P-1)

In the formula (P-1), $Z^{11}$ represents a single bond or an alkylene group having 1 or more and 6 or less carbon atoms, and $X^{11}$ represents a hydrogen atom or a methyl group.

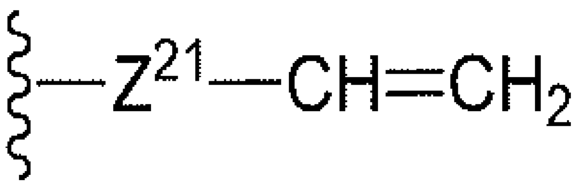

(P-2)

In the formula (P-2), $Z^{21}$ represents a single bond or an alkylene group having 1 or more and 6 or less carbon

atoms.

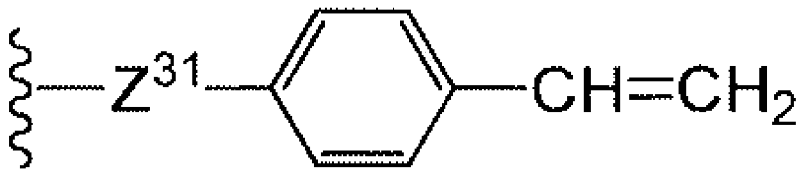

(P-3)

In the formula (P-3), $Z^{31}$ represents a single bond or an alkylene group having 1 or more and 6 or less carbon atoms.

The protective layer may contain fluorine atom-containing resin particles. When the fluorine atom-containing resin particles are contained, the protective layer can have improved abrasion resistance.

Examples of the resin contained in the fluorine atom-containing resin particles are as follows.

The resin may be a polytetrafluoroethylene resin, a polychlorotrifluoroethylene resin, a polytetrafluoroethylenepropylene resin, a polyvinyl fluoride resin, a polyvinylidene fluoride resin, or a polydichlorodifluoroethylene resin. Particles containing, of the above-described resins, a plurality of resins may be used. Of the above-described resins, the fluorine atom-containing resin particles may be formed of a polytetrafluoroethylene (PTFE) resin from the viewpoint of improving the dispersibility.

In observation of a section of the surface layer, for the fluorine atom-containing resin particles, the arithmetic mean of long diameters of primary particles measured from a secondary electron image captured using a scanning electron microscope (average primary particle size) may be 150 nm or more and 300 nm or less from the viewpoint of improving the dispersibility and suppressing potential variation. The fluorine atom-containing resin particles may have an average primary particle size of 180 nm or more and 250 nm or less.

In the protective layer, the content of the fluorine atom-containing resin particles, relative to the total mass of the protective layer, may be 5 mass% or more and 40 mass% or less, or 25 mass% or more and 35 mass% or less.

The protective layer may contain additives such as an antioxidant, an ultraviolet absorbent, a plasticizer, and a leveling agent. Specific examples include hindered phenol compounds, hindered amine compounds, sulfur compounds, phosphorus compounds, benzophenone compounds, siloxane modified resins, silicone oil, polystyrene resin particles, polyethylene resin particles, and boron nitride particles.

The protective layer can be formed by preparing a protective layer-forming coating solution containing the above-described materials and a solvent, using the coating solution to form a coating film on the photoconductor layer, and drying and/or curing the coating film. Examples of the solvent used for the coating solution include alcohol-based solvents, ketone-based solvents, ether-based solvents, sulfoxide-based solvents, ester-based solvents, and aromatic hydrocarbon-based solvents.

The protective layer may have a film thickness of 0.50 μm or more and 10 μm or less, or 1 μm or more and 7 μm or less.

Surface processing of photoconductor drum

In the present disclosure, the photoconductor drum may be subjected to surface processing. The surface processing can further stabilize the behavior of a cleaning unit (cleaning blade) brought into contact with the photoconductor drum. Examples of the method of the surface processing include a method of pressing a mold having protruding portions to the surface of the photoconductor drum to transfer the shape, a method of performing mechanical polishing to impart an irregular shape, and a method of causing a powder to collide with the surface of the photoconductor drum to roughen the surface. In this way, recessed portions or protruding portions are formed in the surface layer of the photoconductor drum, to thereby further stabilize the behavior of the cleaning unit brought into contact with the photoconductor drum.

The recessed portions or protruding portions may be formed over the whole region of the surface of the photoconductor drum, or may be formed in a portion of the surface of the photoconductor drum. When the recessed portions or protruding portions are formed in a portion of the surface of the photoconductor drum, the recessed portions or protruding portions can be formed at least over the whole region that comes into contact with the cleaning unit (cleaning blade).

In the case of forming recessed portions, a mold having protruding portions corresponding to the recessed portions can be pressed to the surface of the photoconductor drum to transfer the shape, to thereby form the recessed portions in the surface of the photoconductor drum.

EXAMPLES

Hereinafter, the present disclosure will be described further in detail with reference to Examples. However, the present disclosure is not limited to the Examples.

In EXAMPLES, top emission-type multilayer organic EL elements were produced such that, on a substrate, an anode, a hole injection layer, a hole transport layer, a light emitting layer, a first electron transport layer, a second electron transport layer, an electron injection layer, a cathode, a first protective layer, a second protective layer, and a third protective layer are sequentially formed. The light emitting layer was formed using a red light emitting material and a host material.

On a silicon substrate having a wiring layer disposed thereon, a titanium (Ti) film having a thickness of 40 nm was formed as the anode by a sputtering method. The film was patterned by photolithography, to form a Ti pixel array having square pixel apertures and wiring. The pixel apertures were formed so as to have sides of 20 μm.

Subsequently, the silicon substrate having been subjected to UV/ozone cleaning and materials were attached to a vacuum deposition apparatus and the apparatus was evacuated to $1.0 \times 10^{-4}$ Pa ($1 \times 10^{-6}$ Torr). Subsequently, the hole injection layer was formed so as to have a film thickness providing an interference structure intensifying the emission wavelength. Subsequently, the light emitting layer containing the red light emitting material was formed. Subsequently, the first electron transport layer, the second electron transport layer, and the electron injection layer were sequentially formed so as to have film thicknesses providing an interference structure intensifying the emission wavelength. Subsequently, the cathode was formed.

Furthermore, the first protective layer being a silicon nitride film formed by a CVD process, the second protective layer being an aluminum oxide film formed by an ALD process, and the third protective layer being a silicon nitride film formed by a CVD process were sequentially formed. In this way, the organic light emitting element was produced.

Afterglow lifetime and exposure time

In each of Examples, the organic light emitting element was measured for afterglow lifetime.

For the afterglow lifetime, excitation was caused using pulse laser and the time elapsed until the light emitting intensity attenuated to 1/e of the initial value was measured and calculated.

For exposure time, evaluations were performed in the patterns of 1 μs and 20 μs.

Evaluation of image quality

Organic light emitting element (OLED) chips produced on a silicon substrate were cut and 17 chips were attached to a PCB substrate. The PCB substrate on which the OLED chips were mounted was prepared and disposed on a casing equipped with a lens array to produce a print head.

The print head thus produced was mounted on a modified model of a copier manufactured by CANON KABUSHIKI KAISHA (trade name: imageRUNNER iR-ADVC5051) and evaluation of image quality was performed.

Subsequently, an electrophotographic photoconductor was mounted on the station of the magenta process cartridge. A test chart having an image ratio of 5% was output on 30000 vertical A4 size sheets. Subsequently, halftone images were output and evaluated in terms of image quality (whether or not vertical streaks or ghost occurred) in accordance with grades below. The results will be described in Table 2.

A: no defects such as vertical streaks and ghost are observed.
B: vertical streaks, ghost, or the like is observed under magnification.

Table 2

| | Afterglow lifetime T1 /s | Exposure time T2 /s | T2/T1 | Image quality after output of 30000 sheets |
|---|---|---|---|---|
| Example 1 | 10 n | 1 μ | 100 | A |
| Example 2 | 0.9 μ | 1 μ | 1.1 | A |
| Example 3 | 50 n | 20 μ | 20 | A |
| Example 4 | 2 μ | 20 μ | 10 | A |
| Comparative Example 1 | 15 μ | 1 μ | 0.067 | B |

(continued)

| | Afterglow lifetime T1 /s | Exposure time T2 /s | T2/T1 | Image quality after output of 30000 sheets |
|---|---|---|---|---|
| Comparative Example 2 | 30 μ | 20 μ | 0.067 | B |

As described in Table 2, the configurations of Examples 1 to 4 provided high image quality after output of 30000 sheets. The configurations of Examples 1 to 4 provided high image quality inferentially because the exposure time was longer than the afterglow lifetime and hence the emitted afterglow affected the photoconductor less.

On the other hand, the configurations of Comparative Examples 1 and 2 provided low image quality after output of 30000 sheets. This was inferentially because, in the configurations of Comparative Examples 1 and 2 in which the afterglow lifetime was longer than the exposure time, the afterglow emitted to the photoconductor to form an unintended latent image on the photoconductor.

Thus, the afterglow lifetime of the organic light emitting element is made shorter than the exposure time for the photoconductor, to thereby provide an image forming apparatus that provides high image quality.

As has been described so far, the use of the configuration in which the afterglow lifetime is shorter than the exposure time can provide an image forming apparatus according to the present disclosure in which afterglow can be suppressed and the image quality is high. In addition, the use of the configuration in which the afterglow lifetime is shorter than the light emission interval period can provide an image forming apparatus in which afterglow can be suppressed and the image quality is high.

The present disclosure can also have the following embodiments.

Embodiment 1

An image forming apparatus comprising: an exposure light source comprising an organic light emitting element; and a photoconductor configured to receive light emitted from the organic light emitting element,
wherein a light emitting intensity of the organic light emitting element at end of supply of current to the organic light emitting element is defined as $L_0$, a period from the end of supply of current to the organic light emitting element to quenching of the organic light emitting element is defined as T1, a period from start of supply of current to the organic light emitting element to the end of supply of current to the organic light emitting element is defined as T2, and
T1 and T2 satisfy a relation of a formula (a):

$$(a)\ T1 < T2.$$

Embodiment 2

The image forming apparatus according to Embodiment 1, wherein T1 and T2 satisfy a relation of a formula (b):

$$(b)\ T2/T1 > 1.0.$$

Embodiment 3

The image forming apparatus according to Embodiment 1 or 2, wherein a period from the end of supply of current to the organic light emitting element to start of supply of current to the organic light emitting element is defined as T3, and T1 and T3 satisfy a relation of a formula (c):

$$(c)\ T1 < T3.$$

Embodiment 4

An image forming apparatus comprising: an exposure light source comprising an organic light emitting element; and a photoconductor configured to receive light emitted from the organic light emitting element,
wherein a light emitting intensity of the organic light emitting element at end of supply of current to the organic light emitting element is defined as $L_0$, a period from the end of supply of current to the organic light emitting element to quenching of the organic light emitting element is defined as T1, a period from the end of supply of current to the organic light emitting

element to start of supply of current to the organic light emitting element is defined as T3, and
T1 and T3 satisfy a relation of a formula (c):

$$(c)\ T1 < T3.$$

Embodiment 5

The image forming apparatus according to any one of Embodiments 1 to 4, wherein the organic light emitting element has a top emission structure.

Embodiment 6

The image forming apparatus according to any one of Embodiments 1 to 5, wherein the organic light emitting element comprises a light emitting layer comprising a light emitting material and the light emitting material emits fluorescence.

Embodiment 7

The image forming apparatus according to any one of Embodiments 1 to 5, wherein the organic light emitting element comprises a light emitting layer comprising a light emitting material and the light emitting material emits phosphorescence.

Embodiment 8

The image forming apparatus according to Embodiment 6, wherein the light emitting material has a condensed polycyclic hydrocarbon skeleton.

Embodiment 9

The image forming apparatus according to Embodiment 8, wherein the light emitting material is a hydrocarbon compound.

Embodiment 10

The image forming apparatus according to any one of Embodiments 6 to 9, wherein the light emitting layer comprises a compound different from the light emitting material and the compound has a condensed polycyclic hydrocarbon skeleton.

Embodiment 11

The image forming apparatus according to Embodiment 10, wherein the condensed polycyclic hydrocarbon skeleton is a naphthalene skeleton, an anthracene skeleton, a phenanthrene skeleton, a fluorene skeleton, a pyrene skeleton, a triphenylene skeleton, a chrysene skeleton, a tetracene skeleton, or a perylene skeleton.

Embodiment 12

The image forming apparatus according to Embodiment 7, wherein the light emitting material is a metal complex.

Embodiment 13

The image forming apparatus according to Embodiment 12, wherein the light emitting material is an iridium complex or a platinum complex.

Embodiment 14

The image forming apparatus according to Embodiment 6, wherein the fluorescence is delayed fluorescence.

Embodiment 15

The image forming apparatus according to Embodiment 6, wherein the light emitting layer further comprises a delayed fluorescence material and a lowest excitation singlet energy of the delayed fluorescence material is higher than a lowest excitation singlet energy of the light emitting material.

Embodiment 16

The image forming apparatus according to Embodiment 15, wherein the light emitting layer further comprises an organic compound different from the delayed fluorescence material and a lowest excitation singlet energy of the organic compound is higher than a lowest excitation singlet energy of the light emitting material.

Embodiment 17

The image forming apparatus according to any one of Embodiments 1 to 16, wherein T1 is less than 1 μs.

Embodiment 18

The image forming apparatus according to any one of Embodiments 1 to 17, wherein the organic light emitting element has an interference structure.

Embodiment 19

The image forming apparatus according to Embodiment 18, wherein the organic light emitting element comprises a reflective layer, a first electrode, a light emitting layer, and a second electrode, and
light emitted from the light emitting layer is intensified between the reflective layer and the light emitting layer.

Embodiment 20

The image forming apparatus according to Embodiment 18, wherein the organic light emitting element comprises a first electrode, a light emitting layer, and a second electrode, and
light emitted from the light emitting layer is intensified between the first electrode and the second electrode.

The present disclosure can provide an image forming apparatus that can provide high image quality.

While the present disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.

## Claims

**1.** An image forming apparatus (40) comprising:

an exposure light source (28) comprising an organic light emitting element; and
a photoconductor (27) configured to receive light (29) emitted from the organic light emitting element,

wherein a light emitting intensity of the organic light emitting element at end of supply of current to the organic light emitting element is defined as $L_0$,
a period from the end of supply of current to the organic light emitting element to quenching of the organic light emitting element is defined as T1, a period from start of supply of current to the organic light emitting element to the end of supply of current to the organic light emitting element is defined as T2, and

T1 and T2 satisfy a relation of a formula (a):

$$\text{(a) } T1 < T2.$$

**2.** The image forming apparatus according to claim 1, wherein T1 and T2 satisfy a relation of a formula (b):

$$(b)\ T2/T1 > 1.0.$$

**3.** The image forming apparatus according to claim 1 or 2, wherein a period from the end of supply of current to the organic light emitting element to start of supply of current to the organic light emitting element is defined as T3, and T1 and T3 satisfy a relation of a formula (c):

$$(c)\ T1 < T3.$$

**4.** An image forming apparatus (40) comprising:

an exposure light source (28) comprising an organic light emitting element; and
a photoconductor (27) configured to receive light (29) emitted from the organic light emitting element,

wherein a light emitting intensity of the organic light emitting element at end of supply of current to the organic light emitting element is defined as $L_0$,
a period from the end of supply of current to the organic light emitting element to quenching of the organic light emitting element is defined as T1, a period from the end of supply of current to the organic light emitting element to start of supply of current to the organic light emitting element is defined as T3, and

T1 and T3 satisfy a relation of a formula (c):

$$(c)\ T1 < T3.$$

**5.** The image forming apparatus according to any one of claims 1 to 4, wherein the organic light emitting element has a top emission structure.

**6.** The image forming apparatus according to any one of claims 1 to 5, wherein the organic light emitting element comprises a light emitting layer comprising a light emitting material, and
the light emitting material emits fluorescence.

**7.** The image forming apparatus according to any one of claims 1 to 5, wherein the organic light emitting element comprises a light emitting layer comprising a light emitting material, and
the light emitting material emits phosphorescence.

**8.** The image forming apparatus according to claim 6, wherein the light emitting material has a condensed polycyclic hydrocarbon skeleton.

**9.** The image forming apparatus according to claim 8, wherein the light emitting material is a hydrocarbon compound.

**10.** The image forming apparatus according to any one of claims 6 to 9, wherein the light emitting layer comprises a compound different from the light emitting material, and
the compound has a condensed polycyclic hydrocarbon skeleton.

**11.** The image forming apparatus according to claim 10, wherein the condensed polycyclic hydrocarbon skeleton is a naphthalene skeleton, an anthracene skeleton, a phenanthrene skeleton, a fluorene skeleton, a pyrene skeleton, a triphenylene skeleton, a chrysene skeleton, a tetracene skeleton, or a perylene skeleton.

**12.** The image forming apparatus according to claim 6, wherein the light emitting layer further comprises a delayed fluorescence material, and
a lowest excitation singlet energy of the delayed fluorescence material is higher than a lowest excitation singlet energy of the light emitting material.

**13.** The image forming apparatus according to claim 12, wherein the light emitting layer further comprises an organic compound different from the delayed fluorescence material, and
a lowest excitation singlet energy of the organic compound is higher than a lowest excitation singlet energy of the light emitting material.

**14.** The image forming apparatus according to any one of claims 1 to 13, wherein T1 is less than 1 μs.

**15.** The image forming apparatus according to any one of claims 1 to 14, wherein the organic light emitting element has an interference structure.

FIG. 1A

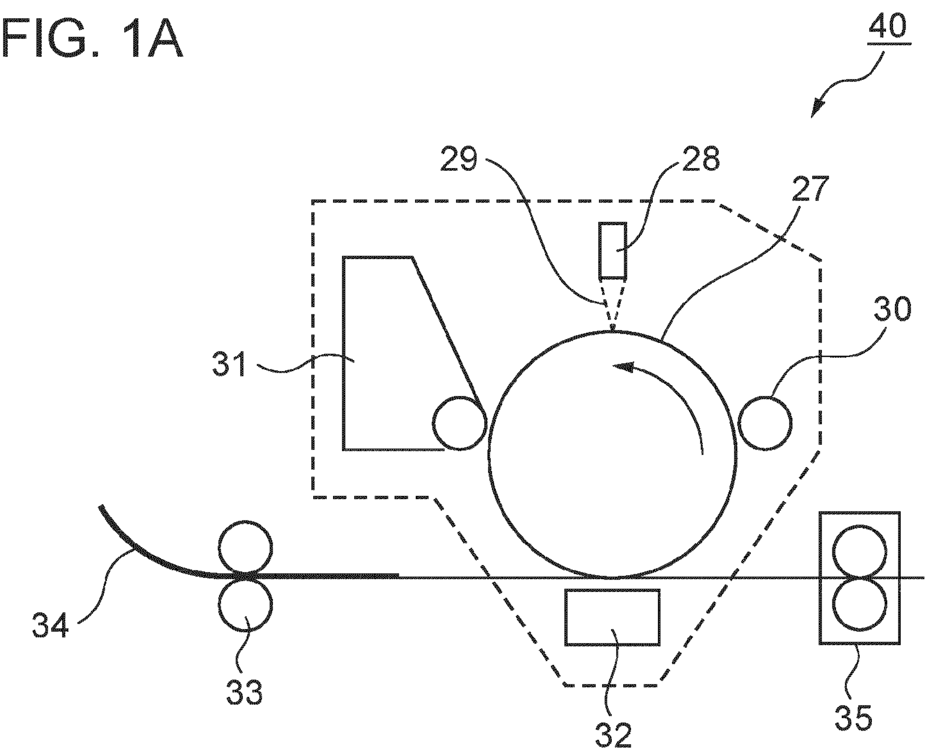


FIG. 1B

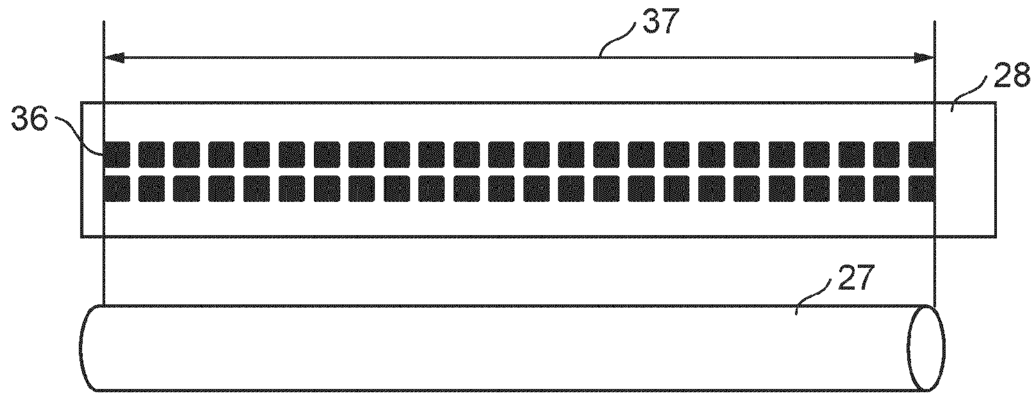


FIG. 1C

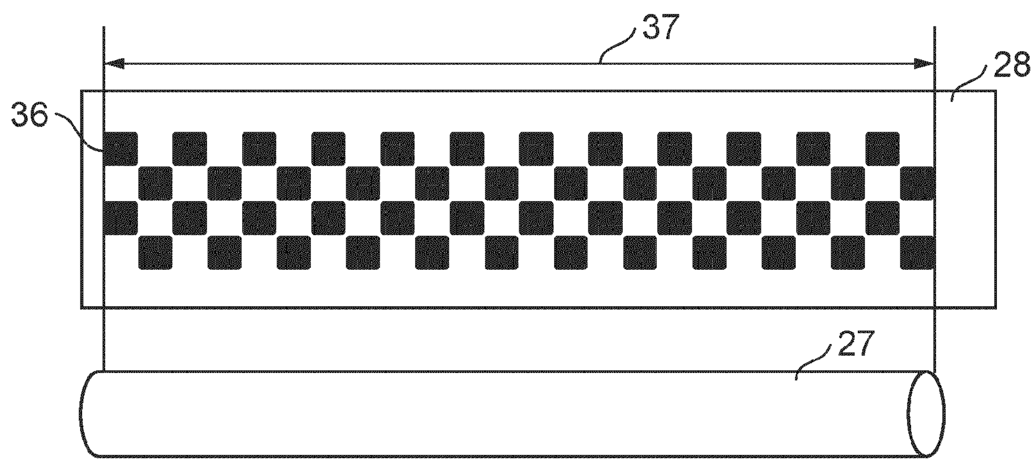

FIG. 2

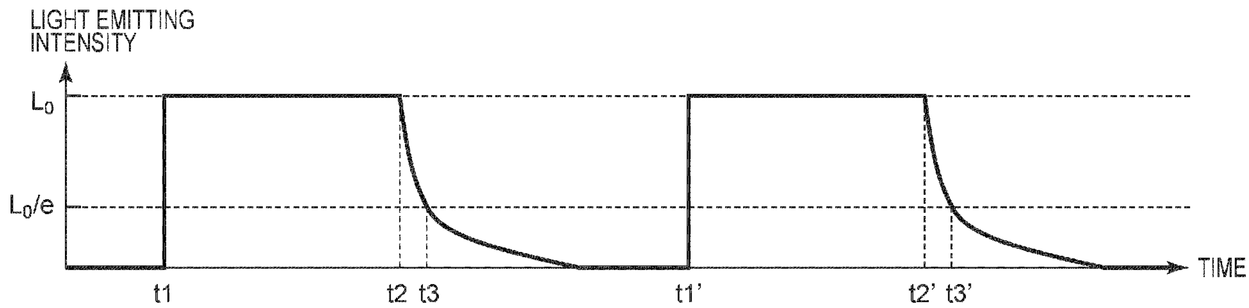

FIG. 3

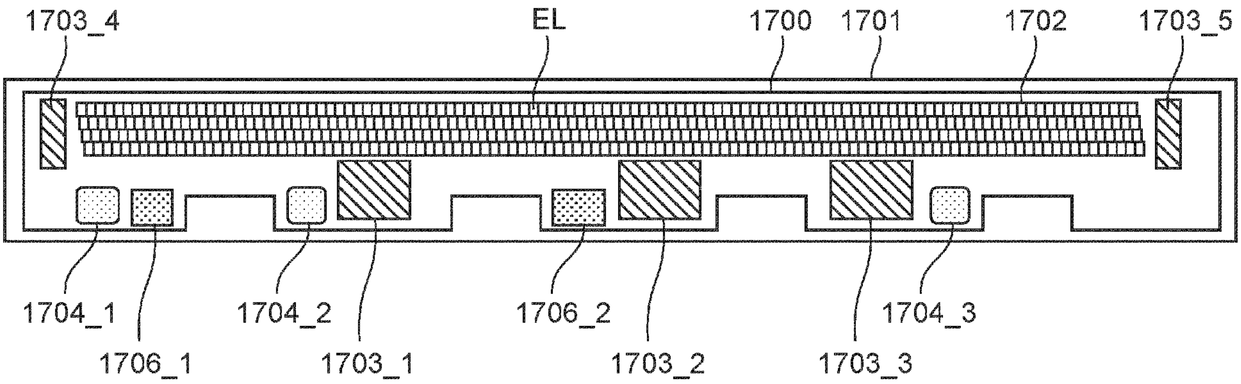
1703_4
EL
1700
1701
1702
1703_5
1704_1
1706_1
1704_2
1703_1
1706_2
1703_2
1703_3
1704_3

FIG. 4A

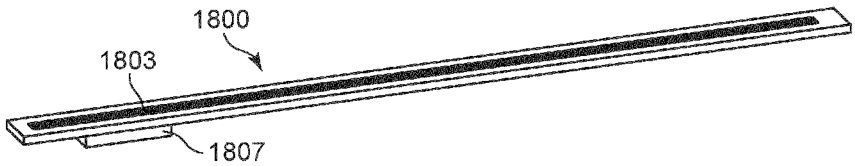


FIG. 4B

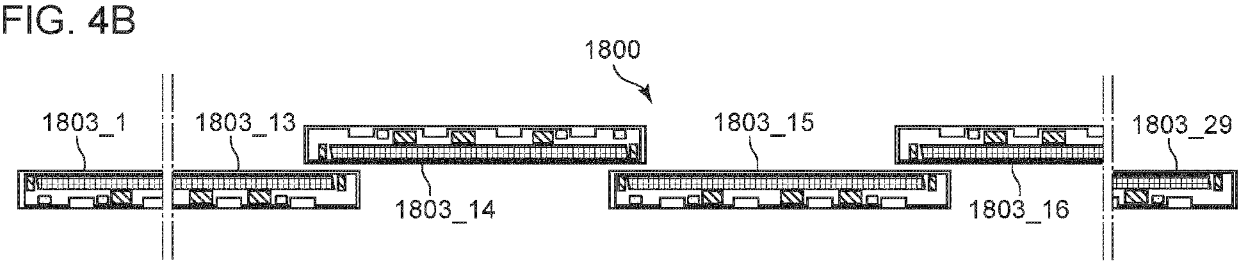


FIG. 4C

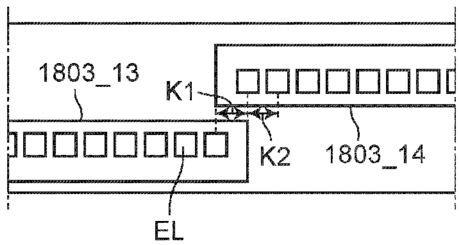

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007128040 A